# DEMANDE DE BREVET EUROPEEN

(11) **EP 4 568 452 A1**
(43) Date de publication de la demande: **11.06.2025**
(21) Numéro de dépôt: 24218197.2
(22) Date de dépôt: 06.12.2024
(51) Int. Cl.: H10F 39/12, H01L 21/78

(54) **PROTOCOLE D'AMINCISSEMENT DU SUBSTRAT ARRIÈRE DE PUCES INDIVIDUELLES RAPPORTÉES PAR COLLAGE HYBRIDE DE TYPE DIE-TO-WAFER**

(30) Priorité: 08.12.2023 FR 2313880
(71) Demandeur: Commissariat à l'Energie Atomique et aux Energies Alternatives, 75015 Paris (FR)
(72) Inventeur: BOUIS, Renan, 38054 GRENOBLE (FR); BOURJOT, Emilie, 38054 GRENOBLE (FR); LADNER, Carine, 38054 GRENOBLE (FR)
(74) Mandataire: INNOV-GROUP

(57) **Abrégé**

Un procédé de réalisation d'un dispositif microélectronique par collage hybride de puces individuelles sur une plaque poignée, de type Die-to-Wafer (D2W), comprend un protocole d'amincissement du substrat arrière des puces. Le protocole comprend un meulage de pré-amincissement (62), exécuté par exemple par polissage mécanochimique, du substrat arrière des puces individuelles une fois rapportées sur la plaque. Ce meulage est précédé de la formation (61) d'une couche de protection des tranchées formées par les espaces entre les puces individuelles rapportées, qui sont non-concernées par l'amincissement. Vient ensuite une gravure de rectification (67) de la hauteur du substrat arrière de chacune des puces individuelles rapportées, exécutée par voie chimique humide, permettant d'éliminer la TTV («*Total Thickness Variation*»). Cette gravure est sélective à l'égard d'un élément d'arrêt contenu dans les substrats respectifs des puces rapportées, et qui est utilisé pour arrêter la gravure à un niveau sensiblement uniforme pour chacune des puces.

## Description

### Domaine technique de l'invention

L'invention se rapporte de manière générale au domaine de l'industrie de la microélectronique, et concerne plus particulièrement l'intégration tridimensionnelle (3D) pour des dispositifs microélectroniques, les termes "dispositifs microélectroniques" désignant des dispositifs incluant des dispositifs obtenus par les nanotechnologies.

L'invention propose un procédé de réalisation d'un dispositif microélectronique avec assemblage en 3D de puces individuelles par collage hybride sur une plaque de matériau semiconducteur (« *wafer »* en anglais), aussi appelée plaque ou wafer "poignée" en référence à sa fonction de support des puces ainsi collées, le procédé comprenant un protocole amélioré d'amincissement (« *grinding* » en anglais) du substrat arrière des puces individuelles retournée, qui est mis en oeuvre une fois les puces individuelles rapportées transférées sur la plaque poignée.

Elle trouve des applications, notamment, pour la fabrication de microsystèmes et composants à haute performance, tels que systèmes microélectromécaniques (MEMS) ou nanoélectromécaniques (NEMS), des actionneurs, des composants radiofréquences (RF), des dispositifs de puissance, ou de dispositifs microélectroniques ou optoélectroniques comme par exemple des capteurs d'image (ou imageurs) en technologie CMOS (de l'anglais « *complementary metal-oxide-semiconductor* ») ou autre.

### Arrière-plan technologique

L'intégration 3D consiste à assembler verticalement par collage (« *bonding* » en anglais) des dispositifs microélectroniques selon une structure à trois dimensions (3D), au lieu de se limiter à une structure planaire à deux dimensions (2D), tout en n'utilisant que des protocoles de traitement 2D pour la réalisation des deux dispositifs séparément. Elle repose sur le collage, l'un au-dessus de l'autre, de dispositifs microélectroniques conçus chacun sur un substrat semi-conducteur respectif, et ayant chacun une structure planaire dont les surfaces respectives ont été ultra polies, et dont l'un est retourné à l'effet du collage su l'autre dispositif.

Plus particulièrement, les surfaces respectives des dispositifs microélectroniques à empiler, par lesquelles ces dispositifs sont superposés, comportent des zones de collage dédiées, par exemple des zones métalliques ou HBM (de l'anglais « *Hybrid Bonding Metallization* ») qui sont isolées par un matériau diélectrique. Ces zones peuvent, ou non, être connectées électriquement à des transistors ou à d'autres éléments actifs ou passifs préalablement réalisés sous la surface de chacun desdits dispositifs, par l'intermédiaire de connexions verticales traversant le substrat desdits dispositifs (aussi appelées TSV pour « *Through Silicon Vias* » lorsque ce substrat est à base de silicium). En assemblant les deux dispositifs verticalement l'un contre l'autre, les zones de collage respectives des deux dispositifs entrent en contact, en établissant le cas échéant des connexions électriques verticales entre des éléments de ces dispositifs, au travers des différentes couches. En variante ou en complément, on peut réaliser après collage des connexions conductrices verticales traversant le substrat du dispositif supérieur pour permettre la connexion électrique entre les différents éléments fonctionnels des deux dispositifs empilés. Ainsi, l'assemblage vertical des deux dispositifs empilés par retournement et collage de l'un sur l'autre (aussi appelé « *flip chip* » en anglais) permet à ces deux dispositifs de communiquer ensemble directement par des connexions électriques verticales courtes, établies à travers l'interface de collage, en évitant toute connexion extérieure (« *wire-bonding* » en anglais). La réduction des longueurs des interconnexions augmente la vitesse des communications entre les différents éléments fonctionnels des dispositifs ainsi assemblés, et réduit la dissipation d'énergie par effet Joule et donc l'élévation de la température.

Divers procédés technologiques existent pour réaliser un assemblage 3D, qui peuvent être différemment adaptés aux exigences spécifiques des applications visées. Ces procédés sont applicables au collage sur une plaque poignée, avec ou sans couche intermédiaire, aussi bien d'une plaque semiconductrices (« *wafer(s)* ») sur laquelle des puces ont été réalisées (on parle alors de plaque "produit" pour désigner cette plaque), que de puces individuelles (« *die(dices)* »). On parle de collage de plaque-à-plaque (ou W2W, de l'anglais « *Wafer-to-Wafer bonding* ») ou de collage de puce-à-plaque (ou D2W, de l'anglais « *Die-to-Wafer bonding* »), respectivement. Bien entendu, le nombre de couches de dispositifs empilés ne se limite pas à deux. On peut toujours ajouter une n-nième couche de dispositif(s) par-dessus un empilement de dispositifs déjà assemblés verticalement, du moment que la surface supérieure dudit empilement qui est destinée à recevoir le(s) nouveau(x) dispositif(s) est suffisamment propre, plate et lisse. Dans le cas contraire, des défauts de collage c'est-à-dire des zones non collées appelées vides (« *voids* » en anglais), *i.e.,* des bulles d'interface, peuvent apparaître.

L'avantage direct de l'intégration 3D réside dans la réduction de la surface du dispositif microélectronique qui est obtenu. L'intégration 3D répond ainsi à un besoin d'augmentation de la compacité des circuits microélectroniques en permettant d'empiler verticalement les dispositifs et donc d'intégrer plus de fonctionnalités sur une même surface de substrat.

Mais l'intégration 3D permet en outre d'atteindre indirectement bien d'autres avantages. Elle permet ainsi une plus grande efficacité du dispositif fonctionnel obtenu, avec notamment une vitesse de communication plus élevée et un budget énergétique réduit, comme évoqué *supra,* du fait de la forte densité et du raccourcissement des interconnexions entre les dispositifs empilés. Elle autorise également l'hybridation des technologies, les fonctionnalités pouvant en effet être réparties sur différents dispositifs destinés à être empilés, et ces derniers pouvant dès lors être réalisés séparément par la mise en oeuvre de technologies de réalisation sur un substrat qui sont spécifiques à chacun des dispositifs. On peut ainsi, par exemple, choisir la finesse de la gravure, les règles de dessin ou des solutions de réalisation planaires propres à chacun des dispositifs, avant de les assembler verticalement par collage On peut alors parler d'intégration 3D hétérogène.

L'intégration 3D fait appel à de nombreuses compétences technologiques, en raison de la complexité de sa mise en oeuvre. Elle nécessite notamment de maîtriser les principales briques technologiques suivantes :
o- l'assemblage des différentes plaques ou puces par un procédé de collage ad-hoc, lequel assemblage comprend notamment un aspect lié au détachement du dispositif à transférer de son support d'origine, ainsi qu'un aspect lié aux contraintes d'alignement dudit dispositif sur le support de destination (i.e., la plaque poignée) ;
o- l'amincissement du substrat arrière du (ou des) dispositif(s) rapporté(s), c'est-à-dire le substrat du dispositif supérieur retourné, une fois les dispositifs assemblés par collage afin d'en réduire l'épaisseur et permettre, le cas échéant, la poursuite de l'intégration 3D ; et,
o- la réalisation des connexions verticales ou vias (TSV) entre les dispositifs empilés verticalement après leur assemblage par collage, en traversant le substrat du dispositif supérieur pour permettre la connexion électrique entre les différents éléments fonctionnels des dispositifs empilés, cette réalisation devant être exécutée avec des contraintes particulières (notamment un budget en température réduit) afin de ne pas endommage l'interface de collage des dispositifs empilés.

Pour la mise en oeuvre d'un transfert de type D2W, l'assemblage comprend la désolidarisation préalable, de leur substrat d'origine, de la (ou des) puce(s) individuelle(s) à transférer. On parle aussi d'individualisation (ou de "singulation", qui est un anglicisme) pour désigner cette étape. L'assemblage comprend aussi le report de puces individuelles retournées, avec la collecte des puces et leur placement en position retournée, cette étape étant réalisée par la tête d'un outil de collecte et de placement de composants (souvent appelé système « *pick and place* » qui signifie « collecte et placement » en anglais).

La présente invention adresse plus particulièrement la problématique de l'amincissement du substrat de la (ou des) puce(s) transférée(s), qui intervient après le report, par collage de type D2W, des dispositifs microélectroniques individuels ainsi rapportés sur la plaque poignée.

Dans des applications non limitatives de l'invention qui seront considérées ici, le recours à l'intégration 3D est prévu pour assembler verticalement par collage, d'une part un dispositif support en technologie CMOS standard, en-dessous, et d'autre part une pluralité d'éléments photosensibles (par exemple des photodiodes) d'un dispositif optoélectronique tel qu'un imageur CMOS, au-dessus, pour former la matrice d'éléments photosensibles de l'imageur.

Les imageurs fabriqués de cette manière, dits imageurs à éclairage arrière ou BSI (« *BackSide Illumination* » en anglais) sont aujourd'hui largement utilisés en raison de leurs avantages spécifiques. Ces avantages comprennent un meilleur facteur de remplissage (défini comme le rapport de la surface de la zone de capture de la lumière sur la surface totale occupée sur le substrat de silicium) et une meilleure collecte de la lumière, par rapport aux technologies d'imageurs à éclairage avant. Ils sont particulièrement avantageux dans les applications dans lesquelles un ensoleillement partiel et d'autres conditions de faible luminosité peuvent exister. Des imageurs BSI ont été utilisés initialement dans des domaines spécifiques nécessitant une matrice très sensible à la lumière, par exemple dans les caméras de sécurité à faible luminosité, les caméras de microscope et les systèmes d'astronomie, pour ne citer que ces quelques exemples. Les progrès de cette technologie permettent aujourd'hui de l'utiliser dans l'électronique grand public, par exemple pour réaliser des appareils photo intégrés dans les petits produits grand public comme les smartphones. Dans ce type d'applications, l'appareil photo utilise généralement des capteurs à pixels actifs en technologie CMOS à éclairage arrière, dits aussi imageurs BSI-CMOS.

Pour la réalisation d'un tel imageur BSI-CMOS, on connaît un procédé de collage hybride pour réaliser un imageur comprenant des photodiodes collées sur une plaque CMOS traditionnelle dans laquelle un réseau d'interconnexions en métal a été réalisé pour assurer le câblage des photodiodes. Le collage est de type W2W, une matrice de photodiodes étant transférée avec une plaque produit sur laquelle les photodiodes ont été réalisées. Cette technologie permet d'obtenir un dispositif BSI-CMOS dans lequel la matrice active de l'imageur CMOS, à savoir une matrice d'éléments photosensibles (appelés « pixels », ce terme venant de la contraction de « *picture element* » en anglais) réalisés par des photodiodes, est disposée sur la surface supérieure (celle recevant la lumière incidente) alors que le câblage de la matrice est disposé derrière la couche des photodiodes de la matrice active. Ce résultat est obtenu en retournant la plaque produit pendant la fabrication et en la collant sur la plaque poignée, puis en amincissant le substrat arrière c'est-à-dire le substrat au verso de la plaque produit retournée (étape de meulage, ou « *grinding* »), de sorte que la lumière peut atteindre la couche des photodiodes sans passer par la couche de câblage. Le gain, en termes facteur de remplissage, qui est obtenu en déplaçant ainsi le câblage des photodiodes de la surface supérieure de la plaque produit vers la surface inférieure de la microstructure, est d'autant plus important que les pixels sont de petite taille.

Néanmoins, si une ou plusieurs des photodiodes sont inutilisables en raison d'un quelconque défaut intervenu lors de leur réalisation en pleine plaque sur leur plaque semiconductrice d'origine (*i.e.*, sur la plaque produit), il ne sert à rien de faire le collage car le dispositif obtenu risque de ne pas être opérationnel, du moins pas de manière optimale. Une photodiode défectueuse peut donner un pixel noir dans l'image numérique acquise par l'imageur.

Selon une nouvelle approche, on souhaite donc réaliser un assemblage de type D2W des photodiodes en tant que puces individuelles, afin de pouvoir trier les puces avant de les reporter sur la plaque, et avoir ainsi la possibilité d'éliminer les puces non-fonctionnelles (i.e., de ne rapporter que des puces fonctionnelles, dont le bon fonctionnement a été vérifié), ce qui n'est pas possible avec un collage de type W2W.

Une difficulté particulière provient de la grande dispersion d'épaisseur, ou TTV (de l'anglais « *Total Thickness Variation* ») des puces rapportées par collage sur la plaque poignée, qui est induite de manière inhérente par l'amincissement (« *thinning* ») collectif des puces par meulage (« *grinding* »), par lequel l'épaisseur des puces rapportées passe d'environ 775µm à environ 15 à 25µm. Un tel résultat de meulage est toutefois obtenu au prix d'une forte dégradation de la TTV, puisque ce meulage introduit des différences de hauteurs fortes entre les puces individuelles. Une fois le meulage terminé, on doit alors effectuer un amincissement complémentaire, moins agressif par polissage du substrat arrière des photodiodes retournées et collées au-dessus de la plaque CMOS standard, pour enlever la zone d'écrouissage induite par le meulage. Ceci requiert beaucoup d'étapes de polissage mécanochimique, ou CMP (de l'anglais *« Chemical and Mechanical Polishing »).*

Le polissage par CMP est certes une technologie viable pour créer des surfaces planes en effectuant un aplanissement global (on dit parfois "une planarisation", ce qui est un anglicisme) de topographies résultant des traitements qui sont classiquement réalisés en microélectronique industrielle (dépôt, lithographie, gravure, etc.). En particulier, l'aplanissement global des puces est effectué à l'aide d'une couche d'oxyde (ou d'un matériau minéral, de manière plus générale) qui a été formée au-dessus de la plaque pour remplir les espaces entre les puces afin de favoriser la l'aplanissement par CMP. Mais certains de ces traitements sont toutefois assez difficiles à réaliser en pratique, compte tenu le cas échéant de la topographie de la surface à polir et/ou de la nature des matériaux à attaquer pour assurer ce polissage, ce qui est le cas dans l'application envisagée ici d'un polissage après meulage du substrat arrière de puces individuelles rapportées par collage de type D2W.

En résumé, le besoin existe d'un protocole de traitement (dit « *process flow* » en anglais) permettant de réaliser un dispositif microélectronique par collage hybride de type Die-to-Wafer (D2W), en collant des puces individuelles correspondant par exemple à des photodiodes formant les cellules actives d'un imageur, sur une plaque poignée qui peut être une plaque de câblage desdites cellules actives de l'imageur, au lieu de coller sur la plaque poignée une plaque semiconductrice (plaque produit) comportant une matrice unitaire de telles photodiodes par collage de type Wafer-to-Wafer (W2W).

Une difficulté réside dans le fait que l'amincissement du substrat arrière des puces individuelles rapportées, réalisé par des opérations classiques de meulage après un collage hybride de type D2W, cause une telle dispersion d'épaisseur (TTV) des puces après meulage, que le polissage à réaliser ensuite par CMP est complexe à mettre en oeuvre. En effet, les différences de hauteur entre les puces rapportées qui résultent du meulage (et qui sont estimées à environ 2.5 µm, voire plus, au minimum) ne peuvent pas être gommées, c'est-à-dire effacées, par ce moyen sans complexifier fortement les protocoles de CMP mis en oeuvre. Il semble nécessaire, à tout le moins, de protéger voire réparer les structures non concernées par l'amincissement, notamment les métallisations au niveau de l'interface de collage, dans les espaces entre les puces rapportées.

L'homme du métier appréciera que le besoin précité, même s'il est présenté ci-dessus dans le contexte de la fabrication d'un imageur CMOS par collage hybride de photodiodes individuelles, peut se rencontrer pour la réalisation de bien d'autres circuits microélectroniques, lorsqu'il est nécessaire d'amincir le substrat arrière de tout type de dispositifs microélectroniques rapportés par collage de type D2W. La solution qui est ici proposée, conformément à des modes de mise en oeuvre de l'invention, peut donc trouver à s'appliquer dans diverses applications de la microélectronique, qui sont multiples et variées.

Le document US20180301365A1 divulgue le collage de type D2W de puces individuelles ayant des épaisseurs différentes, sur une plaquette de silicium. Il est indiqué les puces peuvent être fabriquées et individualisées avec une couche d'oxyde aplanie ayant pour fonction de protéger les structures arrières métallisées. Les faces avant des puces sont alors collées à une première plaque poignée de sorte que les structures respectives soient alignées sur un plan commun. Le matériau du substrat des faces arrière des puces collées est ensuite aminci jusqu'à atteindre une épaisseur uniforme, puis est collé à une deuxième plaque poignée après dépôt d'une nouvelle protection. L'assemblage ainsi obtenu est ensuite retourné, et la première plaque poignée ainsi que la couche protectrice comprenant les débris potentiels de découpe et de manipulation sont enlevées. Les structures postérieures sont ensuite révélées, ce qui permet d'obtenir un assemblage composite comprenant la deuxième plaque poignée et une ou plusieurs puces uniformément amincies qui y sont collées, autorisant d'autres étapes d'assemblage par collage.

Le document SG177817A1 concerne le procédé propriétaire *SmartCut*^{™}*,* qui comprend une implantation ionique et un recuit de fractionnement. Il est divulgué des méthodes de fabrication de structures semi-conductrices comprennent l'implantation d'espèces atomiques dans une matrice porteuse ou une plaquette pour former une région affaiblie dans la matrice porteuse ou la plaquette, et le collage de la matrice porteuse ou de la plaquette à une structure semi-conductrice. La structure semi-conductrice peut être traitée tout en utilisant le support ou la plaquette pour manipuler la structure semi-conductrice. La structure semi-conductrice peut être collée à une autre structure semi-conductrice, et la matrice ou la plaquette de support peut être divisée le long de la région affaiblie qu'elle contient. Des structures semi-conductrices collées fabriquées à l'aide de ces méthodes sont également divulguées.

Le document US2023154914A1 divulgue un procédé de réalisation d'un ensemble comprenant une plaquette temporaire et une ou plusieurs tuiles fixées de manière amovible sur ladite plaquette temporaire, de préférence par l'intermédiaire d'une couche adhésive temporaire. Les tuiles comprennent une partie support et une partie de matériau actif. La partie de matériau actif est fixée au support temporaire. L'ensemble comprend en outre une seule couche continue du premier matériau entourant chacune des une ou plusieurs tuiles. Après leur aplanissement arrière, les tuiles et la couche continue du premier matériau sont liés à une plaquette porteuse permanente, après quoi la plaquette porteuse temporaire est retirée. Le procédé permet d'obtenir une plaquette hybride comprenant une couche supérieure plane formée du matériau de la couche continue avec un ou plusieurs îlots intégrés à celle-ci, la couche supérieure desdits îlots étant formée par la couche supérieure de la partie de matériau actif de la ou des tuiles.

L'article scientifique de D. Zhuang et J.H. Edgar, "Wet etching of GaN, AlN, and SiC: a review", Materials Science and Engineering: R: Reports, Volume 48, Issue 1, 2005, Pages 1-46, ISSN 0927-796X, https://doi.org/10.1016/i.mser.2004.11.002, passe en revue la gravure humide de GaN, AIN et SiC, y compris la gravure conventionnelle dans des solutions aqueuses, la gravure électrochimique dans des électrolytes et la gravure chimique sélective des défauts dans des sels fondus. Le mécanisme de chaque processus de gravure est discuté. Les paramètres de gravure conduisant à une gravure fortement anisotrope, à une gravure sélective par type de dopant/bande interdite, à une gravure sélective par défaut, ainsi qu'à une gravure isotrope sont examinés. Les formes des puits de gravure et leurs origines sont examinées. Les applications des techniques de gravure humide pour caractériser la polarité des cristaux et la densité/distribution des défauts sont examinées. D'autres applications de la gravure humide pour la fabrication de dispositifs, telles que la production de profils de gravure cristallographiques, sont également examinées.

Le document US20060068586A1 divulgue le processus de fabrication d'imageurs CMOS de type BSI avec une couche d'oxyde enfouie comme couche de passivation.

### Résumé de l'invention

L'invention a pour objectif de remédier au moins en partie aux inconvénients de l'art antérieur exposés ci-dessus, et plus particulièrement de proposer une alternative aux protocoles de traitement connus pour procéder à l'amincissement du substrat arrière des dispositifs microélectroniques rapportés par collage de type Die-to-Wafer (D2W), après retournement et collage sur un substrat poignée.

Pour cela, l'objet de l'invention est un procédé de réalisation d'un dispositif microélectronique comprenant le collage hybride d'une pluralité de puces individuelles qui sont retournées verticalement puis rapportées par collage sur une plaque de matériau semiconducteur, ou plaque poignée, le procédé comprenant, après le collage des puces individuelles rapportées sur la plaque poignée, un protocole d'amincissement du substrat arrière des puces individuelles rapportées sur la plaque poignée qui comprend :
o- un meulage de pré-amincissement du substrat arrière des puces individuelles rapportées sur la plaque poignée, précédé de la formation d'une première couche de protection de tranchées formées par des espaces entre les puces individuelles rapportées sur la plaque poignée, qui sont non-concernées par ledit meulage de pré-amincissement ;
o- suivi d'une gravure de rectification de la hauteur du substrat arrière de chacune des puces individuelles rapportées sur la plaque poignée, exécutée par voie chimique humide desdits substrats, ladite gravure chimique humide étant sélective à l'égard d'un élément d'arrêt contenu dans les substrats et qui est utilisé pour arrêter la gravure à un niveau sensiblement uniforme pour chacune desdites puces.

Dit autrement, le procédé permet de réaliser un produit semiconducteur par un assemblage 3D de type D2W. Avantageusement, les puces individuelles rapportées peuvent donc être préalablement triées, sur la base des résultats d'un test réalisé pour chacune d'elles, de manière à écarter d'éventuelles puces non-fonctionnelles et ne rapporter par collage sur le substrat "poignée" que des puces fonctionnelles uniquement. Le test peut être un test de bon fonctionnement électrique de chaque puce à rapporter. On évite ainsi le risque qu'une puce individuelle qui serait non-fonctionnelle implique le non-fonctionnement, dans son ensemble, du dispositif microélectronique l'incorporant après l'assemblage 3D.

Contrairement aux procédés d'amincissement de l'art antérieur dans lesquels l'amincissement est réalisé par une ou plusieurs étapes successives de polissage mécanochimique (CMP) éventuellement alternées avec des étapes de réparation et/ou de comblement des portions endommagées de la microstructure en cours de réalisation, le procédé selon des modes de mise en oeuvre distingue le meulage d'amincissement proprement dit du substrat arrière des puces individuelles rapportées, d'une part, et la rectification de la hauteur des puces individuelles rapportées, d'autre part, c'est-à-dire par des étapes et des méthodes de traitement bien distinctes. Plus particulièrement, un "pré-amincissement" est tout d'abord réalisé par meulage, et est suivi d'une rectification qui est réalisée par voie chimique, notamment par gravure chimique humide.

En d'autres termes, l'invention rompt avec le préjugé existant dans l'art antérieur suivant lequel le meulage devrait procurer à la fois l'amincissement en soi qui permet de réduire substantiellement (mais relativement uniformément) l'épaisseur du substrat arrière du (ou des) dispositif(s) microélectronique(s) rapporté(s) par collage, d'une part, et la rectification (ou "planarisation") de la surface supérieure de l'empilement vertical résultant du meulage pour lisser cette surface en supprimant tout variation d'épaisseur. En effet, un tel processus unitaire ayant ce double objectif est certes généralement satisfaisant pour amincir le substrat arrière d'une plaque produit rapportée sur une plaque poignée par collage de type W2W, mais il l'est beaucoup moins pour la rectification de la dispersion d'épaisseur (TTV) après le découpage de puces individuelles depuis une plaque donneuse et leur report par collage de type D2W sur une plaque poignée. Du point de vue de la terminologie, et pour rendre compte de l'apport et des spécificités de l'invention, on distingue dans ce qui suit un "meulage de pré-amincissement " (« pre*-thinning grinding* » en anglais) qui laisse la surface meulée avec une planéité relativement grossière mais qui est relativement rapide, d'une part, et une gravure de rectification/"planarisation" de surface ("*surface rectification etching"* en anglais) qui est relativement plus efficace en termes de planéité obtenue mais qui est relativement plus lente, d'autre part. La personne de métier appréciera que la relative lenteur d'une gravure de rectification peut être compensée par le fait qu'elle peut être effectuée collectivement sur tout un lot de plaques, contrairement au meulage qui se fait plaque par plaque.

La première couche de protection, par exemple à base de Nitrure de Silicium (SiN1), est réalisée par-dessus l'ensemble de la microstructure structure après collage des puces individuelles et avant de réaliser le pré-meulage d'amincissement. La couche de protection conforme ainsi obtenue empêche la contamination de la surface de la plaque poignée lors du meulage. Une telle contamination est en effet susceptible d'être causée par l'infiltration de liquide de meulage et/ou de débris de meulage, notamment dans le fond des espaces entre les puces individuelles rapportées, à l'interface avec la plaque poignée.

On peut également réaliser un second dépôt d'une couche de protection par-dessus l'ensemble de la structure après le meulage de pré-amincissement et avant de réaliser la gravure de rectification par voie chimique humide. Par exemple on peut procéder au dépôt conforme d'une seconde couche à base de Nitrure de Silicium (SiN2) de façon similaire au premier dépôt de SiN1. La première couche de protection SiN1 ayant possiblement été endommagée par le meulage de pré-amincissement, la seconde couche de protection SiN2 vient la réparer afin de préserver l'efficacité de la protection de la microstructure, en vue de la gravure de rectification, vis-à-vis des composés chimiques utilisés pour cette gravure. Cette couche de protection SiN2 pallie le caractère fortement isotrope de la gravure de rectification, qui est idéalement une gravure chimique humide (« *chemical wet etching* » en anglais), réalisée à l'aide d'une solution acide, en raison de la sélectivité permise par ce type de gravure.

Certains aspects préférés mais non limitatifs du procédé sont les suivants.

Le procédé peut comprendre, en outre, entre le meulage de pré-amincissement et la gravure de rectification, la formation d'une seconde couche de protection des tranchées formées par les espaces entre les puces individuelles rapportées sur la plaque poignée, qui sont non-concernées par ladite gravure de rectification.

Dans ce cas le procédé peut aussi comprendre, en outre, le retrait de la seconde couche de protection au niveau uniquement des portions planes du substrat arrière des puces individuelles rapportées, par gravure à travers un masque préalablement obtenu par photolithographie d'une couche de résine photosensible, pour découvrir sélectivement le substrat arrière desdites puces en vue de la gravure de rectification par voie chimique humide.

Dans des modes de mise en oeuvre, le matériau de la première couche de protection et/ou le matériau de la seconde couche de protection peuvent être des matériaux à base nitrure, notamment à base de nitrure de silicium.

La gravure de rectification par voie chimique humide peut par exemple être exécutée en utilisant, comme éléments d'arrêt de ladite gravure, une zone ayant un dopage particulier dans le substrat arrière de chacune des puces individuelles rapportées, qui est réalisée dans lesdits substrats à une profondeur déterminée, laquelle profondeur est sensiblement identique pour chacune desdites puces.

Par exemple, le dopage particulier de la zone du substrat arrière de chacune des puces individuelles rapportées qui est utilisée comme élément d'arrêt de la gravure chimique humide, peut alors être un dopage de type P différent du dopage de type P standard dudit substrat arrière.

Dans d'autres es modes de mise en oeuvre, le substrat arrière de chacune des puces individuelles rapportées étant un substrat composite, la gravure de rectification par voie chimique humide peut être exécutée en utilisant, comme éléments d'arrêt de ladite gravure, une couche du substrat composite de chacune des puces individuelles rapportées, qui est réalisée en un matériau spécifique à une profondeur déterminée dans lesdits substrats composites, laquelle profondeur est sensiblement identique pour chacune desdites puces.

Par exemple, le matériau spécifique dans lequel sont réalisés les éléments d'arrêt de la gravure de rectification par voie chimique humide peut alors être un matériau à base d'arséniure de gallium (GaAs), ou à base d'aluminium (Al).

Dans d'autres modes de mise en oeuvre, le substrat arrière de chacune des puces individuelles rapportées étant un substrat de silicium épitaxié de quelques micromètres d'épaisseur, la gravure de rectification par voie chimique humide peut être exécutée en utilisant, comme éléments d'arrêt de ladite gravure, une fine couche du substrat de silicium épitaxié de chacune des puces individuelles rapportées, qui est réalisée en un matériau spécifique à une profondeur déterminée dans lesdits substrats, laquelle profondeur est sensiblement identique pour chacune desdites puces.

Par exemple, la fine couche utilisée comme élément d'arrêt de la gravure de rectification par voie chimique humide peut alors être une fine couche d'oxyde de silicium, ou une fine couche de nitrure de silicium.

Dans d'autres modes de mise en oeuvre, le substrat arrière de chacune des puces individuelles rapportées étant un substrat de silicium-sur-isolant, ou SOI (de l'anglais « *Silicon-on-Insulator* »), la gravure de rectification par voie chimique humide est exécutée en utilisant, comme éléments d'arrêt de ladite gravure, une couche enterrée dans le substrat SOI de chacune des puces individuelles rapportées, qui est réalisée à une profondeur déterminée dans lesdits substrats SOI, laquelle profondeur est identique pour chacune desdites puces.

Par exemple, la couche enterrée du substrat SOI de chacune des puces individuelles rapportées qui est utilisée comme élément d'arrêt de la gravure de rectification par voie chimique humide, peut alors être une couche d'oxyde enterrée, ou BOX (de l'anglais « *Burried Oxyde* ») dudit substrat.

Dans des modes de mise en oeuvre, les puces individuelles rapportées peuvent être des puces préalablement découpées d'une même et unique plaque de matériau semiconducteur donneuse.

Dans des modes de mise en oeuvre, la plaque poignée peut être une plaque réalisée en technologie CMOS traditionnelle.

Dans des modes de mise en oeuvre, le pré- amincissement du substrat arrière des puces individuelles rapportées sur la plaque poignée peut être exécuté par meulage.

Dans des modes de mise en oeuvre, le pré-amincissement du substrat arrière des puces individuelles rapportées sur la plaque poignée peut être exécuté par un procédé connu sous le nom SmartCut^{™} comprenant une implantation ionique et un recuit de fractionnement.

Dans des modes de mise en oeuvre, les puces individuelles peuvent être triées, préalablement à leur report sur la plaque poignée, sur la base des résultats d'un test, de manière à écarter d'éventuelles puces non-fonctionnelles et ne reporter par collage sur la plaque poignée que des puces fonctionnelles uniquement.

Par exemple, un tel test peut être un test de bon fonctionnement électrique des puces.

Un autre objet de l'invention est un imageur couleurs de type BSI Imageur couleurs de type BSI (de l'anglais « BackSide Illumination ») comprenant un dispositif microélectronique avec une matrice d'éléments photosensibles, dans lequel :
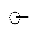 les éléments photosensibles sont des puces individuelles rapportées sur une plaque de matériau semiconducteur, ou plaque poignée ; et,
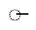 le substrat arrière des puces individuelles rapportées sur le substrat poignée a été traité par la mise en oeuvre du procédé selon le premier aspect ci-dessus,
l'imageur comprenant en outre une matrice de filtres colorés et une matrice de microlentilles réalisées par-dessus le dispositif microélectronique.

Dans cet exemple non-limitatif d'application du procédé, les puces individuelles considérées comprennent des éléments photosensibles (photodiodes) qui, une fois les puces rapportées à la surface de la plaque poignée, sont surmontées de filtres colorés et de microlentilles, en sorte que chaque puce donne un pixel de l'imageur. L'imageur est par exemple un imageur couleurs en technologie CMOS à éclairage par l'arrière, dit imageur BSI-CMOS. Dans des applications comme celle-ci, le recours à l'assemblage 3D selon le procédé conforme à la solution proposée permet de connecter par collage des puces individuelles, préalablement testées électriquement, pour réaliser un imageur sur un substrat poignée comportant déjà un dispositif microélectronique (par exemple en technologie CMOS) dans lequel un réseau d'interconnexions en métal a été réalisé pour assurer le câblage des photodiodes et/ou de leurs transistors de commande.

### Présentation des dessins

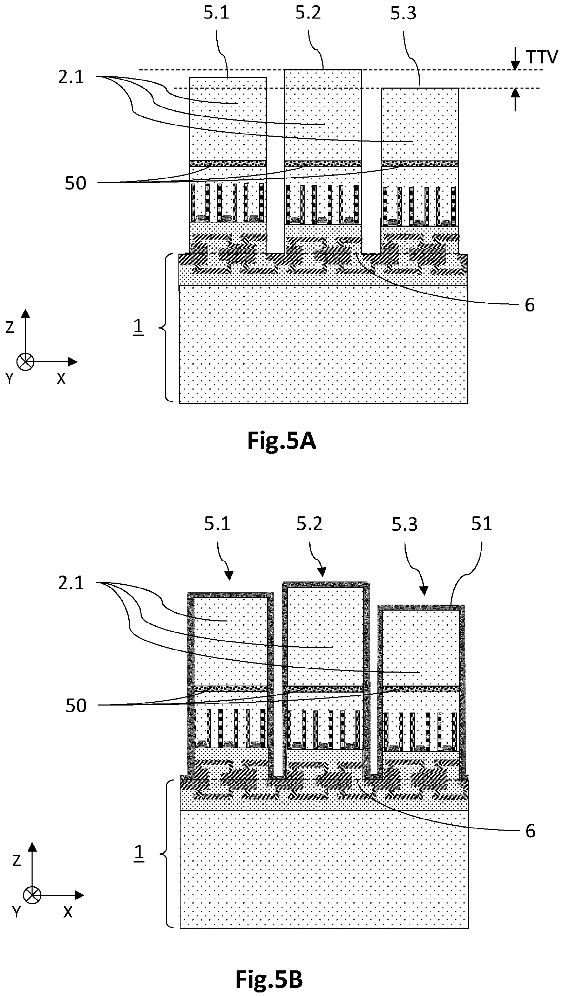

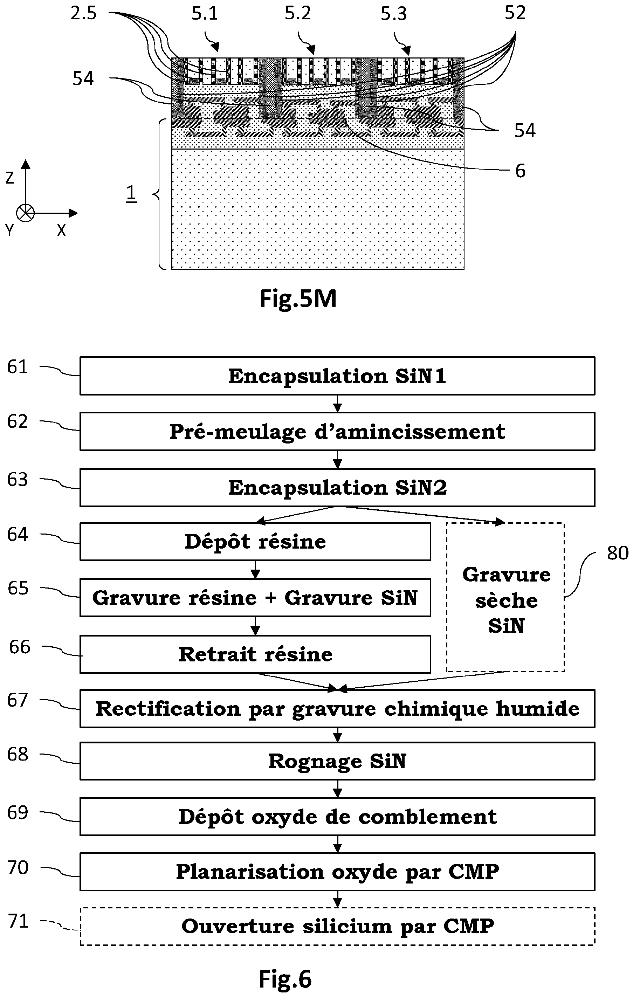

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

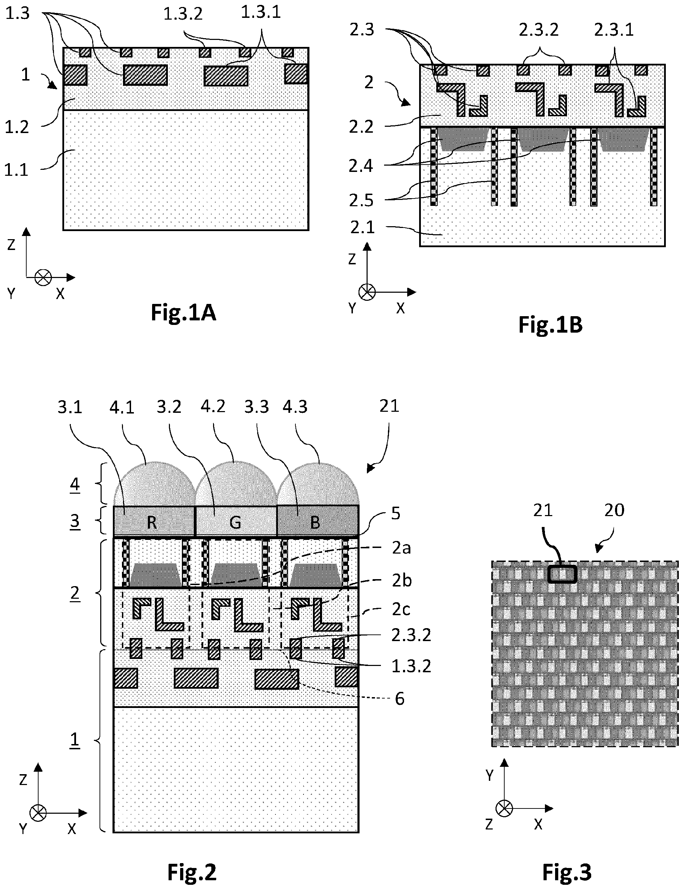

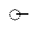 la [Figure 1A] et la [Figure 1B] sont des vues en coupe d'un exemple de plaque poignée et d'un exemple de puce individuelle, respectivement, ladite puce individuelle étant adaptée pour être rapportée, après retournement vertical, par collage de type D2W sur ladite plaque ;
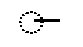 la [Figure 2] est une vue en coupe partielle d'un pixel de couleur d'un imageur BSI-CMOS incorporant un dispositif microélectronique photosensible comprenant la puce de la Figure 1B rapportée sur la plaque poignée de la Figure 1A, et après exécution d'étapes complémentaires pour réaliser des filtres colorés et des microlentilles, notamment ;
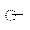 la [Figure 3] est une vue de dessus partielle d'un imageur BSI-CMOS comprenant une matrice de pixels comme le pixel de la Figure 2 ;

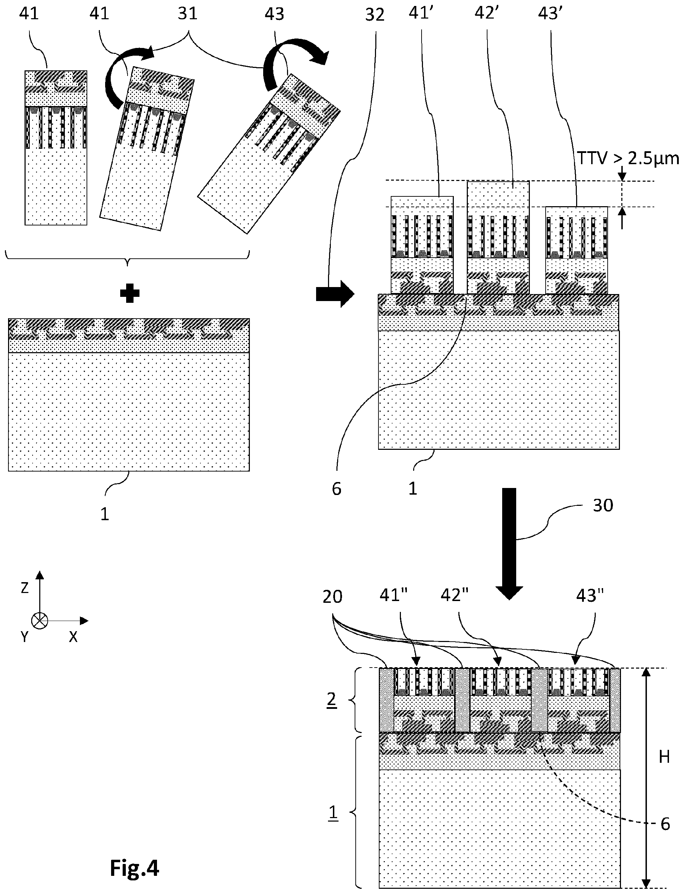

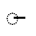 la [Figure 4] est un diagramme fonctionnel figurant schématiquement, avec des vues en coupe, le principe de l'assemblage de type D2W d'un dispositif microélectronique, et illustrant par ailleurs le problème à la base de l'invention ainsi que le résultat attendu de la solution conforme à des modes de mise en oeuvre de l'invention ; et,
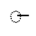 les figures de la [Figure 5A] à la [Figure 5M] illustrent l'évolution d'un exemple de microstructure après l'exécution des différentes étapes, respectivement, d'un protocole de traitement selon des mises en oeuvre de l'invention.

### Description des modes de réalisation

Sur les figures et dans la suite de la description, les mêmes références désignent des éléments identiques ou similaires. De plus, les différents éléments ne sont pas représentés à l'échelle de manière à privilégier la clarté des figures. Par ailleurs, et sauf indication contraire explicite, les différents modes de réalisation et variantes exposés ne sont pas exclusifs les-uns des-autres et peuvent le cas échéant être combinés entre eux.

Le terme "wafer" est un terme venant de l'anglais qui désigne une plaque très fine (aussi appelée "plaquette" du fait de sa faible épaisseur) de matériau semi-conducteur monocristallin sur laquelle des dispositifs microélectronique peuvent être réalisés. Les wafers sont ainsi utilisés pour fabriquer des composants microélectroniques, comme des imageurs. Les wafers sont réalisés avec un matériau semi-conducteur dopé, comme le silicium (Si), l'arséniure de gallium (GaAs) ou le phosphure d'indium (InP). Les wafers présentent des dimensions généralement comprises entre 25,4 mm et 300 mm de diamètre, pour une épaisseur de l'ordre de 0,7 mm. Les wafers sont employés dans l'industrie microélectronique en tant que support de fabrication de microstructures. Cette fabrication emploie des techniques de réalisation telles que par exemple et de manière non limitative le dopage, la gravure, le dépôt d'autres matériaux et la photolithographie. Le matériau semi-conducteur dopé dont le wafer est constitué sert donc de substrat pour la création des microstructures formant les dispositifs microélectroniques qui entrent dans la composition des circuits intégrés, des transistors, des semi-conducteurs de puissance ou des MEMS / NEMS, etc.

Dans ce qui suit, les termes "sensiblement", "environ", ou encore "de l'ordre de" signifient à 10% près, et de préférence à 5% près. Par ailleurs, les termes "compris entre ... et ...", ou des termes équivalents, signifient que les bornes sont incluses, sauf mention contraire explicite.

Par l'expression "formé à base de", utilisée en référence à un matériau et à un élément d'intérêt, on entend que le matériau est un composé formé d'une pluralité d'éléments dont au moins ledit élément d'intérêt.

Par l'expression "matériau comportant majoritairement" un élément d'intérêt, on entend un matériau dont au moins 50% en volume est formé par ou comporte ledit élément d'intérêt.

Par les termes "gravure anisotrope" utilisés en référence à un matériau déterminé, on entend que la vitesse de la gravure dudit matériau n'est pas la même dans toutes les directions pendant le processus de gravure. Au contraire, la gravure s'effectue essentiellement suivant une unique direction seulement, qui est généralement la direction verticale (c'est-à-dire la direction orthogonale au plan d'extension de la surface du matériau à graver). Dit autrement, la structure n'est pas, ou seulement peu gravée suivant une quelconque direction latérale pendant un tel processus de gravure. *A contrario,* une "gravure isotrope" ne privilégie aucune direction de gravure, en sorte que toutes les surfaces exposées sont gravées simultanément, et ce quelle que soit leur orientation dans l'espace, *i.e.,* qu'elles soient horizontales, verticales, ou inclinées.

Par l'expression "polissage mécanochimique" ou CMP (de l'anglais « *Chemical-Mechanical Polishing* »), déjà employée en introduction, on désigne un processus de lissage de la surface d'une plaquette utilisant l'action combinée de forces mécaniques et chimiques ayant comme effet l'enlèvement du (ou des) matériau(x) en surface de la plaque et l'effacement d'une éventuelle topographie de surface, avec pour résultat l'aplanissement de la surface de la plaquette exposée à ce processus.

Par le terme "meulage" (« *grinding* » en anglais), on entend un processus d'amincissement du substrat arrière d'une plaque en matériau semiconducteur à une épaisseur désirée, cet amincissement étant obtenu de manière essentiellement mécanique en pressant la plaque contre une table en rotation relative (appelée meule), sous aspersion d'un fluide de meulage. On obtient l'épaisseur désirée de la plaque après amincissement, en prévoyant une pluralité d'éléments de régulation de la pression mécanique qui sont correctement intégrés dans l'épaisseur du matériau à meuler, et dont les surfaces sont plus résistantes au meulage que les autres surfaces de la plaque.

Par le terme "rectification" on entend une opération de finition consécutive au meulage d'une plaque en matériau semiconducteur, ayant pour objet le parachèvement de la planéité de la surface meulée, qui permet de respecter des tolérances très serrées, inférieures à une dizaine de nanomètres, pour la variation d'épaisseur de la plaque. Lorsque, comme en l'espèce, la variation d'épaisseur de la plaque est due à des différences de hauteur entre des puces individuelles rapportées sur ladite plaque qui était bien plane, on peut également parler de correction de la dispersion de l'épaisseur de ces puces rapportées.

Le cas échéant, c'est-à-dire lorsque cela est nécessaire à la compréhension des modes de mise en oeuvre du procédé, on distinguera le meulage d'amincissement en soi (appelé " meulage de pré-amincissement") d'une microstructure qui ne procure substantiellement qu'une réduction uniforme de l'épaisseur des différents éléments de la microstructure, d'une part, de la rectification de surface qui permet un aplanissement de la surface supérieure de la microstructure en uniformisant la hauteur des éléments considérés, c'est-à-dire en gommant la variation de l'épaisseur totale, ou TTV, de la plaque, qui résulte de la dispersion des hauteurs respectives des puces individuelles rapportées sur la plaque.

Enfin, on définit ici et pour la suite de la description un repère direct tridimensionnel orthogonal (X,Y,Z), où les axes X et Y forment un plan parallèle au plan principal de la plaque "poignée" considérée, et où l'axe Z est orienté de manière sensiblement orthogonale au plan principal de la plaque, cet axe Z étant orienté suivant la direction de l'axe de la gravité. Dans la suite de la description, les termes "vertical » et "verticalement" s'entendent comme étant relatifs à une orientation sensiblement parallèle à l'axe Z, et les termes "horizontal" et "horizontalement" comme étant relatifs à une orientation sensiblement parallèle au plan (X,Y). Par ailleurs, les termes "dessus" et "dessous" ainsi que leurs dérivés (comme "au-dessus" et "au-dessous", ou "par-dessus" et "par-dessous"), ainsi également que les termes "inférieur" et "supérieur", utilisés pour qualifier un élément de la microstructure considérée, s'entendent comme étant relatifs à un positionnement croissant lorsqu'on s'éloigne du wafer vers le haut, *i.e.,* suivant la direction verticale +Z.

Le terme "arrière" et le terme "avant", en revanche, sont utilisés en référence à la face d'une plaque par laquelle les différents traitements sont, ou ont été effectués pour réaliser la microstructure considérée. Ces traitements étant systématiquement réalisés par le haut lorsque la plaque est disposée à plat dans une enceinte utilisée pour effectuer le traitement, la face "avant" est généralement (et par défaut) la face supérieure de la plaque. Toutefois, lorsqu'une plaque ou une puce découpée d'une plaque sont retournées verticalement, leur face avant devient la face inférieure et leur face arrière devient la face supérieure. Le qualificatif "arrière" attribué au substrat semi-conducteur d'une plaque ou d'une puce individuelle est également utilisé en référence à cette convention, en ce sens qu'on désigne par-là la partie du substrat qui est la plus éloignée de la face de ladite plaque ou de ladite puce au niveau de laquelle des traitements ont été réalisés sur le substrat, et que l'on qualifie toujours de face quand bien même la plaque ou la puce ont été retournées verticalement.

Des modes de réalisation particuliers du procédé de collage hybride de type D2W vont être décrits en se référant à l'exemple non limitatif de l'application du procédé à la fabrication d'un dispositif microélectronique tel qu'un capteur d'image numérique (ou "imageur"). Un tel capteur est réalisé sur la base de dispositifs microélectroniques photosensibles, *i.e.,* adaptés pour capter la lumière et la transformer en un courant électrique. Ils sont basés sur des photodétecteurs comme, par exemple des photodiodes en technologie CMOS. Et ils sont opérés en association avec des microlentilles, et également des filtres colorés si le capteur est un capteur d'image numérique en couleurs. Un ou plusieurs tels dispositifs photosensibles ainsi complétés correspondent à un élément d'image, ou pixel.

On appelle "facteur de remplissage" (« *fill factor* » en anglais) le rapport de l'aire d'un pixel qui est sensible à la lumière sur l'aire totale que le pixel occupe à la surface du substrat semiconducteur sur lequel il est réalisé. Les capteurs CCD (de l'anglais « *Charge-coupled Device* ») ont un facteur de remplissage proche de 100%. Dans les capteurs CMOS, il était à l'origine autour de 50 à 70%, mais avec la diminution de la taille des transistors et l'utilisation de microlentilles (grâce auxquelles plus de surface du pixel participe à la collecte des photons), le facteur de remplissage dans les capteurs CMOS s'est beaucoup amélioré.

La plupart des imageurs qui sont composés de pixels de grandes tailles *(i.e.,* de taille supérieure à environ 3 µm de côté) sont éclairés par la face avant. En raison de leur grande taille, la face avant des pixels est relativement peu encombrée par les interconnexions métalliques et les transistors de la chaîne de lecture réalisés au-dessus. Ces pixels n'ont donc pas de problème à collecter la lumière, même sous un fort angle d'incidence. Ils ont par conséquent un facteur de remplissage assez élevé, aux alentours des 80 à 90%. Dans le cas des capteurs intégrant des pixels de taille inférieure ou égale à 2 µm de côté, en revanche, l'illumination en face arrière devient indispensable pour obtenir une surface photosensible la moins encombrée et la plus étendue possible. Un capteur à éclairage arrière, ou capteur BSI (de l'anglais « *BackSide Illumination* »), est un type de capteur d'image numérique qui utilise un agencement particulier des éléments d'imagerie, obtenu notamment par le report sur une plaque "poignée" des photodiodes formant la matrice de capteurs optiques, afin d'augmenter la quantité de lumière capturée et ainsi améliorer les performances de l'imageur sous éclairage faible. Cette brique technologique permet d'obtenir des facteurs de remplissage allant jusqu'à 100%. Elle apporte aussi une réduction de l'épaisseur de l'empilement des couches optiques (microlentille, filtres colorés et couche antireflets) ainsi qu'une plus grande flexibilité dans le dessin des interconnexions métalliques.

On considérera plus particulièrement, dans l'exemple, un imageur en technologie CMOS à éclairage par l'arrière, dit aussi imageur BSI-CMOS. Un tel imageur est un dispositif opto-électronique comportant des éléments capteurs d'image (*i.e.,* les "pixels") réalisés à partir de photodiodes en technologie CMOS. Les capteurs sont des éléments actifs adaptés pour capturer des photons lorsqu'ils sont associés à des microlentilles. Le cas échéant, ils peuvent aussi être associés à des filtres colorés pour la capture d'une image numérique en couleurs, et éventuellement à une couche anti-reflet.

Dans cet exemple d'application du procédé, les puces individuelles qui font l'objet du collage hybride sont des dispositifs microélectroniques photosensibles destinés à former les pixels d'un imageur CMOS couleur, c'est-à-dire un imageur capable de capter des images numériques en couleurs d'une scène. Chacune de ces puces comprend au moins trois éléments photosensibles, sensibles chacun à la lumière blanche, qui sont destinés à être associés à des filtres élémentaires colorés respectifs correspondant à une couleur primaire d'un système trichromatique déterminé, tel que le système RGB (de l'anglais « *Red* », « *Green* » et « *Blue* »)*,* que cet élément photosensible doit détecter. Ces puces sont détachées d'une plaque "produit" sur laquelle elles ont été réalisées. Puis elles sont retournées et rapportées par collage hybride de type D2W sur une plaque "poignée" leur servant de support opérationnel, et qui est par exemple réalisée en technologie CMOS traditionnelle.

Cependant, il va sans dire que les modes de réalisation décrits sont également adaptés à la fabrication d'autres dispositifs microélectroniques intégrés, notamment des dispositifs optoélectroniques différents et/ou conçus de manière ou selon une technologie différente, des MEMS ou des NEMS, ou tous autres dispositifs microélectroniques, qu'ils soient actifs ou passifs.

Les modes de réalisation concernent plus particulièrement la phase d'amincissement du substrat arrière des puces individuelles après qu'elles ont été retournées puis rapportées sur la plaque poignée par collage hybride de type D2W. Un tel amincissement fait partie intégrante de l'assemblage 3D par collage hybride, qu'il soit de type W2W ou de type D2W. Il vise en effet à limiter l'épaisseur du dispositif microélectronique ainsi obtenu, afin notamment de permettre son intégration dans un boîtier de circuit intégré (« *integrated circuit (IC) packaging* » en anglais). En outre, la planéité de la surface arrière du dispositif microélectronique est particulièrement critique lorsqu'il est prévu de continuer la superposition verticale d'au moins un autre dispositif par-dessus l'empilement déjà réalisé.

La **Figure 1A** et la **Figure 1B** montrent, en coupe, une portion d'une plaque poignée 1 et une puce individuelle 2, respectivement. La puce individuelle 2 peut être obtenue par la découpe (« *dicing* » en anglais) d'une plaque donneuse comportant une pluralité de puces identiques ou similaires. La puce 2 est adaptée pour, après retournement vertical, être rapportée par collage hybride sur la plaque poignée 1.

Dans l'exemple illustré par la **Figure 1A**, la plaque poignée 1 comprend un substrat semi-conducteur 1.1, par exemple un substrat en silicium monocristallin. Le substrat 1.1 est légèrement dopé, par exemple d'un dopage de type P. Un tel dopage peut être obtenu par insertion dans le substrat d'atomes de type accepteur d'électrons, comme des atomes de Bore (B).

Au-dessus du substrat 1.1, une couche 1.2 de matériau isolant a été formée, par exemple une couche à base de dioxyde de silicium (SiO2), ou silice. Cette couche peut être obtenue par l'oxydation thermique du silicium, à une température comprise entre 800 et 1200 °C, en utilisant soit de la vapeur d'eau (« *wet oxidation* » ou oxydation humide) soit du dioxygène (« *dry oxidation* » ou oxydation sèche).

Des zones métalliques 1.3, c'est-à-dire des zones faites en un métal tel que le cuivre (Cu), ont été formées dans des niveaux de métallisation de la couche d'isolant 1.2. Les zones métalliques 1.3 comprennent des interconnexions 1.3.1 qui réalisent les connexions électriques nécessaires au fonctionnement des dispositifs microélectroniques tels que la puce 2, qu'il est prévu de rapporter par collage hybride sur la plaque poignée 1. Les zones métalliques 1.3 comprennent également, dans le niveau de métallisation le plus haut *(i.e.,* le plus éloigné du substrat 1.1), des zones métalliques 1.3.2 prévues pour le collage hybride. Certaines au moins des zones métalliques 1.3.2 peuvent également participer aux connexions électriques des dispositifs microélectroniques rapportés. Lorsque le métal est le cuivre, les zones métalliques 1.3 peuvent être réalisées selon le procédé connu sous le nom de "Damascene", ou sa variante "Dual-Damascene". L'homme du métier appréciera que la plaque poignée 1 peut intégrer, en outre, d'autres éléments que les zones métalliques 1.3.1 et 1.3.2 susmentionnées, par exemple des dispositifs actifs comme des transistors, ou encore des MEMS ou des NEMS, etc. Dans un exemple, tous les dispositifs réalisés sur la plaque 1 poignée sont réalisés en technologie CMOS traditionnelle.

La puce 2, dans l'exemple représenté à la **Figure 1B****,** comprend trois éléments photosensibles pour former un pixel couleur d'un imageur. Par exemple, ces éléments photosensibles sont basés chacun sur une photodiode. Pour un imageur BSI-CMOS tel que considéré dans le présent exemple de mise en oeuvre du procédé, les puces à rapporter comme la puce 2 sont réalisées en technologie CMOS.

La puce 2 comprend un substrat semi-conducteur, par exemple en silicium monocristallin 2.1 légèrement dopé, par exemple d'un dopage de type P réalisé par implantation d'atomes de Bore.

Sous la surface supérieure du substrat 2.1, trois photodiodes 2.4 adjacentes deux-à-deux ont été réalisées. Les charges électriques (électrons) d'origine photoélectrique sont stockées dans la zone photosensible de la photodiode 2.4, appelée "noeud de lecture", et qui correspond à la grille d'un transistor CMOS (parfois désignée par le terme « *photogate* » dans la littérature anglo-saxonne) ou d'une paire de transistors CMOS dans le cas d'un pixel à architecture partagée. Il peut s'agir de transistor(s) CMOS à grille de transfert verticale (VTG). Le pixel comprend en outre des transistors pour convertir les charges photo-générées en un signal électrique utile, notamment un transistor suiveur pour lire l'état de charge électrique du noeud de lecture et un transistor de réinitialisation (« *reset* » en anglais) pour décharger le noeud de lecture avant chaque nouvelle acquisition d'image se traduisant par une accumulation de charges d'origine photoélectrique, ainsi éventuellement qu'un transistor de sélection de ligne. Ces éléments peuvent être en nombre différents et être conçus et agencés de différentes manières, selon l'architecture choisie pour le pixel : architecture partagée à deux transistors (2T), architecture à quatre transistors (4T), etc. Il n'entre pas dans le cadre de la présente description de décrire en détail ni la structure ni le fonctionnement d'une telle photodiode.

Chaque photodiode 2.4 est isolée dans un caisson délimité par deux tranchées d'isolation profondes 2.5 qui peuvent être remplies d'oxyde pour former une tranchée d'isolation profonde ou DTI (de l'anglais « *Deep Trench Isolation* »)*.* De préférence, toutefois, les tranchées 2.5 peuvent être des tranchées d'isolation profondes polarisables, ou tranchées CDTI (de l'anglais « *Capacitive Deep Trench Isolation* »). Les tranchées 2.5 sont alors remplies, par exemple, de poly-silicium dopé au Phosphore (P), par exemple avec une concentration de 1×1019 at/cm³. Une passivation de l'interface des tranchées profondes 2.5, qui permet d'éviter le courant d'obscurité, peut ainsi être obtenue essentiellement de façon électrostatique, en polarisant les tranchées CDTI durant l'accumulation d'électrons dans la photodiode 2.4 lors de l'acquisition d'image.

Le substrat 2.1 et ses microstructures 2.4 sont surmontées d'une couche de matériau isolant 2.2 qui, comme la couche 1.2 de la plaque poignée 1, peut être obtenue par oxydation thermique du silicium.

Des zones métalliques 2.3, par exemple en cuivre, ont été formées dans des niveaux de métallisation de la couche de matériau isolant 2.2. Les zones métalliques 1.3 comprennent des interconnexions 1.3.1 qui réalisent les connexions électriques nécessaires au fonctionnement des dispositifs microélectroniques tels que les transistors de commande des photodiodes 2.4. Les zones métalliques 2.3 comprennent également, comme les zones métalliques de la plaque poignée 1, des zones métalliques 2.3.2 prévues pour le collage hybride, et qui sont réalisées dans le niveau de métallisation le plus haut (*i.e.,* le plus éloigné du substrat 2.1). Comme la personne du métier l'aura compris, les zones métalliques 2.3.2 de la puce 2 sont agencées et adaptées pour coopérer avec les zones métalliques 1.3.2 de la plaque poignée 1, en entrant en contact les unes avec les autres pour le collage de ladite puce 2 sur ladite plaque 1. Pour ce qui concerne les aspects tant fonctionnels que structurels ainsi que les procédés de réalisation mis en oeuvre, ce qui a été dit plus haut à propos des zones métalliques 1.3 de la plaque poignée 1 vaut également pour les zones métalliques 2.3 de la puce 2, et n'est pas répété ici.

La **Figure 2** montre la puce 2 de la Figure 1B une fois rapportée, après avoir été retournées verticalement (c'est-à-dire que leur partie basse est devenue la partie haute, et, réciproquement, leur partie haute est devenue la partie basse), par collage hybride sur la face supérieure de la plaque poignée 1, c'est-à-dire au-dessus de ladite plaque 1. La référence 6 désigne l'interface de collage entre la face supérieure de la plaque poignée 1, d'une part, et la face supérieure (avant son retournement vertical) ou plutôt la nouvelle face inférieure (après son retournement vertical) de la puce 2 rapportée, d'autre part. Le substrat arrière de la puce 2 rapportée, dont la face arrière est tournée vers le haut après retournement vertical de la puce, a été aminci afin de réduire son épaisseur d'environ 775 µm à environ 20 à 30 µm, par exemple 25 µm. Cet amincissement est réalisé par le dessus, via un amincissement du substrat arrière.

Les photodiodes de la puce 2 sont sensibles à l'ensemble du spectre de la lumière visible. Une matrice 3 de filtres élémentaires colorés peut également être intégrée au-dessus de la matrice d'une matrice de puces comme la puce 2, pour réaliser un capteur d'image numérique en couleurs, c'est-à-dire afin de permettre l'acquisition par l'imageur d'images en couleurs d'une scène. Chaque photodiode 2.4 est alors adaptée, en combinaison avec l'un desdits filtres élémentaires colorés, pour capter la lumière correspondant à l'une respective des trois couleurs primaires, rouge, vert et bleu, qui sont désignées par les références R, G et B (de l'anglais « *Red* », « *Green* » et « *Blue* »), respectivement. Grâce à cette matrice 3 de filtres élémentaires colorés, chaque photodiode 2.4 du capteur d'image ne voit qu'une seule couleur : rouge, vert ou bleu. A cet effet, chacune des photodiodes 2.4 peut être surmontée du côté supérieur, ou face arrière de la puce rapportée, d'un filtre élémentaire coloré correspondant à la couleur primaire que cette photodiode doit détecter. Dans l'exemple représenté à la Figure 3, la matrice 3 de filtres colorés comprend ainsi les filtres 3.1, 3.2 et 3.3 qui sont de la couleur R, G et B, respectivement, et qui sont disposés chacun au-dessus de l'une des trois photodiodes 2.4, respectivement. En variante, la matrice 3 de filtres élémentaires colorés pourrait être réalisée comme un filtre de Bayer RGB constitué de pastilles colorées des couleurs primaires R, G et B précitées, mais avec deux pastilles vertes ainsi qu'une pastille rouge et une pastille bleue (donc quatre élément photosensibles) pour chaque pixel.

En outre, un réseau de microlentilles 4 peut être disposé au-dessus de la matrice de filtres colorés élémentaires 3. Plus particulièrement, et toujours en référence à la Figure 2, chacun des filtres élémentaires colorés 3.1, 3.2 et 3.3 de la matrice 3 peut être surmonté d'une micro lentille 4.1, 4.2 et 4.3, respectivement, qui est adaptée pour orienter la lumière incidente vers la surface photosensible de la photodiode 2.4 correspondante. Par exemple, les micro lentilles 4.1, 4.2 et 4.3 sont sensiblement hémisphériques.

Enfin, il est généralement prévu une mince couche isolante, ou un assemblage de couches isolantes, entre la matrice 3 de filtres colorés et la surface supérieure des photodiodes 2.4, pour former une structure antireflet 5.

La réalisation en pratique des filtres colorés 3.1, 3.2 et 3.3, ainsi que des micro lentilles 4.1, 4.2 et 4.3 et de la structure antireflet 5, fait appel aux méthodes conventionnelles de la réalisation des imageurs. Plus particulièrement, du fait de la précision requise, les pastilles colorées de la matrice de filtres 3 peuvent être déposées directement sur le pixel correspondant avec une technologie proche de la photolithographie des circuits intégrés, de même que les microlentilles du réseau de microlentilles 4. Ces réalisations ne seront pas décrites plus avant, afin de ne pas alourdir le présent exposé.

La **Figure 3** montre, en vue de dessus une portion d'une matrice de pixels 20 formée de pixels comme le pixel 21 de la Figure 2, surmontés du réseau de filtres colorés 3 de cette figure. Les pixels y sont disposés en lignes et en colonnes après placement et collage hybride sur la plaque poignée, et forment la matrice photosensible d'un imageur BSI-CMOS, dans laquelle chaque puce rapportée correspond à un pixel trichromatique. Un logiciel de l'imageur recrée les couleurs de la scène capturées par la matrice de photodiodes, en tenant compte des courbes de réponse spectrale des filtres colorés et de la structure antireflet 5, pour un résultat final en trichromie RGB.

Avant de décrire plus spécifiquement un exemple de mise en oeuvre du procédé de réalisation d'un dispositif microélectronique par collage hybride de puces individuelles retournées et collées sur une plaque poignée selon l'invention, la phase d'amincissement du substrat arrière des puces ainsi rapportées sur la plaque poignée est replacée dans son contexte, en référence au diagramme schématique de la **Figure 4**. Sur cette figure, la phase d'amincissement est figurée par la "boîte noire" portant la référence 30, au milieu à droite. Le substrat poignée 1 de la Figure 1A d'une part, et une pluralité de puces individuelles 41, 42 et 43 identiques ou similaires à la puce 2 de la Figure 1B, d'autre part, sont représentées séparément en haut à gauche de la Figure 4.

Sur la Figure 4, le retournement vertical (« *up side down* », en anglais) des puces individuelles 41, 42 et 43, par lequel la face supérieure d'une puce avant retournement devient la face inférieure de la puce une fois retournée, et réciproquement, est figuré par les flèches 31. En outre, le collage sur la plaque poignée 1 des puces individuelles 41, 42 et 43 retournées verticalement, par lequel les zones métalliques de collage respectives desdites puces et de ladite plaque entrent en contact les unes avec les autres, est figuré par la flèche 32.

La figure montre en outre, en haut à droite, les puces individuelles une fois retournées puis rapportées sur la plaque poignée 1 après ce retournement vertical. Les puces individuelles 41, 42 et 43 visibles en haut à gauche, une fois rapportées sur la plaque poignée 1 sont référencées en haut à droite de la figure par les références 2.1', 2.2' et 2.3', respectivement, afin de les distinguer des puces individuelles de départ. Une fois placées et collées sur la plaque poignée 1, les puces rapportées (dont les puces 41', 42' et 43' représentées, et d'autres) sont adjacentes les unes aux autres dans le plan horizontal XY au-dessus de la plaque poignée 1, en étant alignées et espacées deux-à-deux, suivant la direction X et également suivant la direction Y.

Comme représenté en haut à droite de la Figure 4, les puces individuelles rapportées 41', 42' et 43' n'ont pas toutes la même hauteur après l'amincissement de leur substrat arrière réalisé collectivement par meulage, laquelle hauteur peut être considérée suivant la direction verticale Z à partir de l'interface de collage 6 localisée verticalement entre la face supérieure de la plaque poignée 1 et la face inférieure des puces rapportées41', 42' et 43'. Ces différences de hauteur impliquent une variation corrélative de l'épaisseur de la structure microélectronique, qui peut être considérée suivant la direction verticale Z à partir de la face arrière du substrat de la plaque poignée 1 (*i.e.,* la face inférieure de ladite plaque 1).

La personne de métier appréciera que l'épaisseur de la plaque poignée 1 et celle de la plaque produit 2 sont supposées constantes, puisque ces deux plaques ont été ultra-polies avant la réalisation des dispositifs correspondants. Les puces individuelles 41, 42 et 43 découpées de leur plaque d'origine (*i.e.,* de la plaque "produit" ou plaque donneuse) ont donc toutes sensiblement la même épaisseur, qui est d'environ 775 µm. Par exemple, les puces présentent une TTV inférieure à 1 µm environ après leur retournement et leur collage sur la plaque poignée 1. La hauteur moyenne des puces rapportées 41', 42' et 43' après le meulage de leur substrat arrière est d'environ15 à 25 µm, mais ces puces rapportées et meulées présentent une dispersion de leur épaisseur totale ou TTV (de l'anglais « *Total Thickness Variation* ») qui est d'environ 2.5 µm, voire plus, au minimum. Cette variation d'épaisseur n'est que la conséquence de l'amincissement du substrat arrière des puces 41, 42 et 43 réalisé après le report desdites puces sur la plaque poignée 1, cet amincissement étant réalisé collectivement par meulage des puces après leur collage sur la plaque poignée 1. A la Figure 4, la TTV est représentée, tout en haut à droite, par l'écart entre la plus grande hauteur et la plus petite hauteur, respectivement, des puces rapportées sur la plaque poignée 1 et meulées qui sont désignées sur ladite figure par les références 41', 42' et 43'.

Après exécution d'un protocole de traitement (« *process flow* », en anglais) 30 selon des mises en oeuvre de l'invention (symbolisé par une flèche verticale orientée de haut en bas, à droite de la Figure 4), le substrat arrière des puces rapportées et meulées 41', 42' et 43' montrée en haut à droite de la figure a été aminci afin de réduire l'épaisseur des puces rapportées à une hauteur comprise entre environ 15 µm et environ 25 µm. La microstructure monolithique ainsi obtenue est représentée en bas à droite de la Figure 4, en étant pointée par la flèche 30. Dans cette partie de la figure, les puces rapportées et meulées telles que désormais amincies par le protocole de traitement 30, portent les références 41", 42" et 43", respectivement. En outre, on peut voir sur la Figure 4 que les espaces vides entre les puces disposées en matrice XY sur la plaque poignée 1, ont été comblés par un matériau isolant de comblement 20, tel qu'un oxyde de comblement (« *interfill oxyde* » en anglais), pour assurer la stabilité de la matrice de pixels et offrir une surface supérieure plane.

Comme représenté en bas à droite de la Figure 4, la hauteur totale H de la structure microélectronique, ici mesurée suivant la direction verticale Z à partir de la face arrière de la plaque poignée 1, est uniforme en tous points de la surface supérieure de ladite microstructure. Dit autrement, les épaisseurs respectives du substrat arrière des puces rapportées et amincies 41", 42" et 43" ont été égalisées par rectification de la surface supérieure des puces rapportées et meulées 41', 42' et 43' qui sont montrées en haut à droite de la Figure 4, cette rectification étant obtenue en aplanissant le substrat arrière desdites puces rapportées et meulées conformément au protocole de traitement 30 selon des modes de mise en oeuvre du procédé de l'invention.

En résumé, et comme la personne du métier l'aura compris, le protocole de traitement représentée symboliquement à la Figure 4 par la flèche 30 permet de faire passer la microstructure de l'état empreint d'une forte TTV qui est représenté en haut à droite de la Figure 4, à l'état sensiblement plan représenté en bas à droite de ladite figure. Et ce protocole de traitement 30 comprend la rectification (*i.e*., l'uniformisation de la hauteur) du substrat arrière 2.1 des puces individuelles rapportées 5.1, 5.2 et 5.3, qui sont obtenus par la mise en oeuvre du procédé selon l'invention.

La séquence d'étapes qui réalise (notamment) le protocole de traitement 30, avec les avantages procurés par la mise en oeuvre de l'invention, va maintenant être décrite en référence aux schémas de la **Figure 5A** à la **Figure 5M** ainsi qu'au diagramme d'étapes de la **Figure 6****.**

A la **Figure 5A****,** on a représenté un exemple de structure microélectronique similaire, en termes de traitements réalisés, à celle représentée en haut à droite de la Figure 4. L'intimité structurelle et fonctionnelle des puces individuelles rapportées 5.1, 5.2 et 5.3 est identique à celle qui ont déjà été présentée plus haut en référence à la Figure 1B pour la puce référencée 2 sur ladite figure (avant retournement vertical de ladite puce). Pour rappel, selon cet exemple non limitatif, les puces individuelles comprennent trois photodiodes BSI-CMOS à éclairage arrière et à isolation par tranchées profondes capacitives (CDTI). La variation d'épaisseur totale (TTV) de la microstructure telle qu'elle peut être constatée après le meulage qui est effectué collectivement pour toutes les puces individuelles 5.1, 5.2 et 5.3 ensuite de leur report par collage sur la plaque poignée 1 , est également visible et référencée en haut de la Figure 5A.

En outre, les puces individuelles rapportées 5.1, 5.2 et 5.3 comportent chacune, dans l'épaisseur de leur substrat arrière, un élément d'arrêt 50 utile pour l'exécution de modes de mises en oeuvre du procédé permettant de gommer cette TTV de manière améliorée, selon l'invention. La personne du métier appréciera en effet que la gravure de rectification qui est spécifique aux modes de mise en oeuvre de l'invention, et qui sera décrite plus loin, est sélective à un tel élément d'arrêt 50 comme il sera indiqué plus bas. Dans l'exemple représenté, cet élément d'arrêt 50 est une zone présentant un dopage particulier, par rapport au dopage de type P du substrat des puces, obtenue par diffusion d'atomes à un certain niveau dans l'épaisseur dudit substrat. En variante, il peut s'agir d'un élément réalisé en un matériau spécifique, dans le cas notamment où le substrat est un substrat de silicium sur isolant ou SOI (de l'anglais « *Silicon-on-Insulator »).*

Quelle que soit sa forme de réalisation, la personne du métier observera que l'élément d'arrêt 50 se trouve, dans le substrat arrière des puces rapportées 5.1, 5.2 et 5.3, au-dessus des photodiodes desdites puces dès lors que ces puces ont été retournées verticalement avant d'être rapportées sur le substrat de la plaque poignée 1. La microstructure telle que représentée à la Figure 5A est la microstructure après report des puces individuelles 5.1, 5.2 et 5.3 sur la plaque poignée 1. C'est cette microstructure qui fait l'objet des étapes de la phase d'amincissement et de rectification du procédé de l'invention. Elle est comparable en termes d'étapes de la procédure mise en oeuvre pour la réaliser, à la structure représentée en haut à droite de la Figure 4, à ceci près que le substrat arrière 2.1 des puces individuelles rapportées 5.1, 5.2 et 5.3 intègre, pour chaque puce, un élément d'arrêt 50 sur lequel on reviendra plus loin.

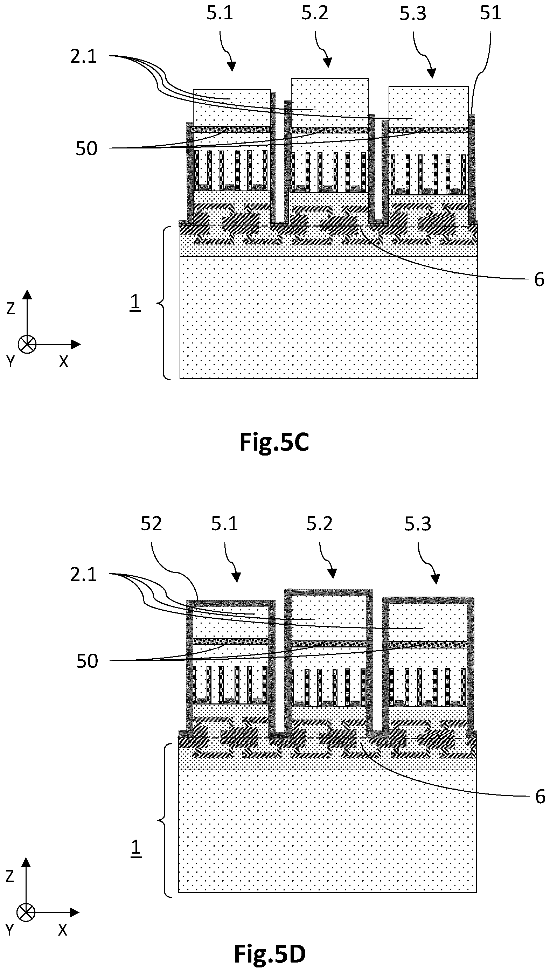

Lors d'une première étape 61 dont le résultat est illustré à la **Figure 5B****,** on forme avant toute chose une protection adaptée pour protéger les éléments profonds de la microstructure lors du meulage de pré-amincissement du substrat arrière des puces rapportées 5.1, 5.2 et 5.3 qui va ensuite être effectué à l'étape suivante 62. A cet effet, on peut effectuer dans cette première étape 61 le dépôt conforme d'une couche de protection 51 sur la face supérieure de la microstructure de la Figure 5A, c'est-à-dire une couche encapsulant (*i.e*., couvrant de manière conforme) le dessus de la structure issue du report des puces individuelles 5.1, 5.2 et 5.3 sur la plaque poignée 1.

Cette étape 61 peut être mise en oeuvre afin d'encapsuler les puces individuelles rapportées 5.1, 5.2 et 5.3 par le matériau de protection de la couche de protection 51, et surtout les espaces profonds en forme de tranchées qui sont formés (du fait du collage de puces individuelles sur la plaque poignée) entre lesdites puces individuelles, ces tranchées n'étant pas concernés par l'amincissement. Cette protection évite que la surface de la plaque poignée 1, au niveau des zones de collage des puces rapportées 5.1, 5.2 et 5.3, *i.e.,* dans les tranchées précitées, ne soit endommagée pendant le meulage du substrat arrière des puces individuelles rapportées 5.1, 5.2 et 5.3. Dans le cas d'espèce, les zones de collage des puces individuelles rapportées 5.1, 5.2 et 5.3 peuvent en effet comprendre du cuivre à nu qui peut se trouver dans le fond de ces tranchées. La protection par la couche de protection 51 empêche également la contamination de la surface de la plaque poignée 1 qui pourrait être causée par l'infiltration de fluide de meulage et/ou de débris produits par le meulage. On notera que la plaque poignée 1 peut également être lavée tout au long du processus de meulage, avec par exemple de l'eau désionisée, ce qui contribue également à prévenir la contamination de la microstructure.

Dans des modes de mise en oeuvre, la couche de protection 51 peut être une couche réalisée à base de nitrure, par exemple de nitrure de silicium ou Si3N4 (noté SiN par raccourci). Ce matériau dur est apte à protéger le cuivre au niveau des interfaces de collage, des différentes agressions susceptibles de causer des dégradations structurelles et/ou des contaminations lors du meulage et lors de la gravure chimique humide auxquels la microstructure sera ensuite soumise, pour le pré-amincissement et pour la rectification du substrat arrière des puces, respectivement. Un tel nitrure est préférable à, par exemple, un oxyde comme l'oxyde de silicium (SiO2) qui serait une autre option pour le matériau de protection, car le SiO2 est hermétique aux molécules d'eau (H2O) susceptibles d'être présentes dans le fluide de meulage et/ou d'intervenir dans le cadre de la mise en oeuvre d'étapes de gravure humide. D'autres matériaux, notamment les nitrures de titane (TiN) et de tungstène (WN), ainsi que différents types d'oxydes nitrurés, peuvent également être utilisés, en variante ou en complément du nitrure de silicium (SiN).

Une couche de protection en nitrure de silicium de bonne qualité, *i.e.,* de qualité compatible avec les contraintes de la microélectronique, peut par exemple être obtenue par dépôt chimique en phase vapeur (CVD), par exemple par un dépôt chimique en phase vapeur à basse pression (LPCVD). Un tel procédé fonctionne à température relativement élevée. En variante, on peut former la couche de nitrure de silicium 51 par le dépôt chimique en phase vapeur assisté par plasma (PECVD), qui fonctionne à température relativement plus basse et sous vide. La couche d'encapsulation protective 51 ainsi obtenue est de préférence une couche mince : elle peut, par exemple, avoir une épaisseur d'une centaine de nanomètres (nm).

Dans une deuxième étape 62, on effectue un pré-amincissement du substrat arrière des puces individuelles rapportées 5.1, 5.2 et 5.3, de manière à en ramener l'épaisseur à une épaisseur comprise entre 20 et 30 µm au-dessus des interfaces de collage des puces sur la plaque poignée, par exemple de l'ordre de 25 µm. Cet amincissement peut être effectué par un meulage (« *grinding* ») conventionnel du substrat arrière des puces, qui permet d'enlever la majeure partie du silicium de ce substrat par abrasion, pour atteindre une hauteur des puces de, environ, 20 à 30 µm. Il peut donc être relativement rapide, au bénéfice du temps global de traitement. Il peut par exemple être réalisé en utilisant une meule à dents de diamant ainsi qu'un liant comme fluide de meulage. Ceci permet d'éliminer des épaisseurs importantes de silicium assez rapidement, tout en limitant les contraintes générées dans le silicium. La hauteur des puces peut ainsi être ramenée d'environ 775 µm à environ 25 µm, avec une TTV de l'ordre de 2,5 µm, environ, dans le meilleur des cas.

Le résultat obtenu par cette deuxième étape 62 est illustré à la **Figure 5C****,** sur laquelle on peut voir que l'épaisseur du substrat arrière des puces rapportées 5.1, 5.2 et 5.3 a été sensiblement amincie par rapport à la microstructure telle que représentée à la Figure 5A (on rappelle que les dessins ne sont pas à l'échelle). En variante, le pré-amincissement pourrait être obtenu par mise en oeuvre d'une technique connue sous le nom de SmartCut^{™}, qui comprend une implantation ionique suivie d'un recuit de fractionnement ou de séparation (« *splitting* » en anglais), au lieu du meulage précité. Cette technique est largement utilisée pour le transfert de couches cristallines minces d'un substrat à un autre, notamment dans le contexte de la technologie au silicium sur isolant ou SOI (de l'anglais « *Silicon-on Insulator* »). Avantageusement, l'épaisseur de la couche qui peut ainsi être séparée du substrat donneur peut être déterminée avec une grande précision en ajustant l'énergie d'implantation d'ions légers, par exemple des ions d'hydrogène (H+) ou d'hélium (He+), et donc la profondeur de la zone de rupture ainsi enterrée. Le recuit thermique (entre environ 350°C et environ 600°C) provoque ensuite la croissance des fissures enterrées, jusqu'à la fracturation du silicium et donc la séparation de la portion supérieure du substrat arrière des puces rapportées, ce par quoi le pré-amincissement est obtenu. Dans le contexte de l'invention, cette technique SmartCut^{™} permet de bien maîtriser l'ampleur du pré-amincissement ainsi réalisé, c'est-à-dire l'épaisseur de la portion supérieure du substrat arrière des puces qui est enlevée par ce moyen.

La personne de métier appréciera que, avec cette étape de pré-amincissement 62, on ne cherche pas à éliminer la TTV par un traitement de type CMP en visant à obtenir une planéité de qualité de la surface arrière du substrat (*i.e*., une planéité de l'ordre de quelques nanomètres). Ceci distingue l'invention des méthodes d'amincissement basées sur la CMP que la personne du métier considérerait nécessairement, et uniquement, étant donné la grande épaisseur de silicium à enlever qui l'oriente naturellement vers un procédé mécanochimique. La personne de métier considérerait en effet la combinaison de plusieurs opérations de CMP, opérées sous différents paramètres et/ou avec différents outils, et éventuellement entrecoupées d'étapes de réparation et/ou de protection de la microstructure, pour tenter d'obtenir une planéité satisfaisante par un polissage de type CMP.

C'est aussi la raison pour laquelle, dans le cadre de la présente description, on parle d'un "pré-amincissement" pour désigner l'étape 62 du procédé. En effet le résultat obtenu à l'issue de cette étape 62 réside essentiellement dans un amincissement relativement conséquent et rapide mais également relativement imparfait en termes de planéité. En outre, selon l'invention, le meulage réalise une première attaque du substrat arrière des puces qui permet seulement d'amincir substantiellement l'épaisseur du substrat arrière des puces individuelles rapportées 5.1, 5.2 et 5.3, et qui n'est pas définitive. Elle sera suivie par la mise en oeuvre d'une attaque supplémentaire réalisant un amincissement complémentaire, relativement moins rapide mais relativement beaucoup plus fin, c'est-à-dire plus efficace en termes d'aplanissement de la surface attaquée. Il s'agit de l'étape 67 du procédé illustré par la Figure 6, qui sera explicitée plus bas. Ainsi qu'il ressortira de la description qui suit, cette autre étape 67 d'amincissement est effectuée, après l'étape 62, préférentiellement par voie chimique et plus particulièrement par gravure chimique humide. Cette étape 67 permet d'uniformiser les niveaux respectifs de la surface supérieure du substrat arrière des puces individuelles rapportées 5.1, 5.2 et 5.3, c'est-à-dire d'aplanir la surface supérieure de la microstructure de manière à gommer la TTV introduite par le meulage, ce qui permet le cas échéant de poursuivre l'intégration 3D sans défaut de collage pour empiler de nouveaux dispositifs par-dessus cette surface.

Comme le montre symboliquement la Figure 5C, la couche de protection 51 ressort endommagée de l'étape 62 de meulage de pré-amincissement. Elle peut même avoir plus ou moins disparu au niveau des portions supérieures des flancs des tranchées qui s'étendent verticalement entre les puces individuelles rapportée 5.1, 5.2 et 5.3, à proximité de la surface supérieure de la microstructure. Si la couche de protection 51 en nitrure de silicium est trop abimée, *i.e.,* n'est plus assez intègre, elle risque de ne pas être assez résistive aux attaques chimiques ultérieures qui sont envisagées pour gommer la TTV conformément à des modes de mise en oeuvre de l'invention.

C'est pourquoi, dans une troisième étape 63 dont le résultat est illustré par la **Figure 5D****,** et avant la poursuite des opérations à réaliser pour uniformiser la hauteur du substrat arrière des puces individuelles rapportée 5.1, 5.2 et 5.3, on peut prévoir de former une nouvelle protection de la microstructure, *i.e.,* une protection complémentaire à celle procurée par ce qu'il reste de la couche 51. Ceci peut être réalisé en effectuant, par exemple, le dépôt conforme d'une seconde couche de protection 52. Dans des modes de mise en oeuvre, cette nouvelle couche de protection 52 encapsule de nouveau toute la microstructure. Elle permet de réparer ou de compléter la première couche de protection 51 qui avait été antérieurement déposée à l'étape 61, mais qui peut avoir été détériorée par le meulage de pré-amincissement qui a été appliqué, à l'étape 62, au substrat arrière des puces individuelles rapportée 5.1, 5.2 et 5.3.

Dans des modes de mise en oeuvre, la seconde couche de protection 52 peut être une couche réalisée à base d'un nitrure de même nature que le nitrure de la première couche de protection 51 réalisée à l'étape 61. De préférence, le nitrure de la seconde couche de protection 52 est alors également du nitrure de silicium (SiN) lorsque le nitrure de la première couche de protection 51 est lui-même du nitrure de silicium (SiN). Ce qui a été dit plus haut à propos de la première couche de protection 51, concernant ses caractéristiques, son mode de réalisation et les variantes pouvant être considérées, s'applique aussi et vaut également pour la seconde couche de protection 52, et n'est donc pas répété ici.

La personne du métier appréciera que la mise en oeuvre de cette étape 63 de formation d'une deuxième couche de protection 52 dépend notamment de la qualité d'origine de la première couche de protection 51, et de la mesure dans laquelle ladite couche 51 est potentiellement endommagée par l'étape 62 de meulage de pré-amincissement. Plus la protection apportée par la première couche de protection 51 est réduite à l'issue de ce meulage, et plus la réalisation de la seconde couche de protection 52 est importante.

Le procédé se poursuit avec le retrait de la seconde couche 52 de protection au niveau uniquement des portions planes du substrat arrière 2.1 des puces individuelles rapportées 5.1, 5.2, 5.3, pour découvrir sélectivement le substrat arrière 2.1 desdites puces, en vue de la gravure de rectification par voie chimique humide. Ce retrait est effectué par gravure à travers un masque préalablement obtenu par photolithographie d'une couche de résine photosensible. Plus particulièrement, les étapes du procédé qui suivent visent à découvrir le silicium du substrat arrière 2.1 des puces individuelles rapportées 5.1, 5.2 et 5.3, à la surface supérieure horizontale desdites puces, afin de pouvoir égaliser leur hauteur par gravure chimique humide conformément aux modes de mise en oeuvre de l'invention. A cet effet, on enlève le nitrure de silicium (SiN) de la deuxième couche de protection 52 uniquement au niveau des portions planes de ladite couche 52, lesquelles forment un capuchonnement (« *capping* » en anglais) au niveau supérieur du substrat arrière des puces rapportées 5.1, 5.2 et 5.3.

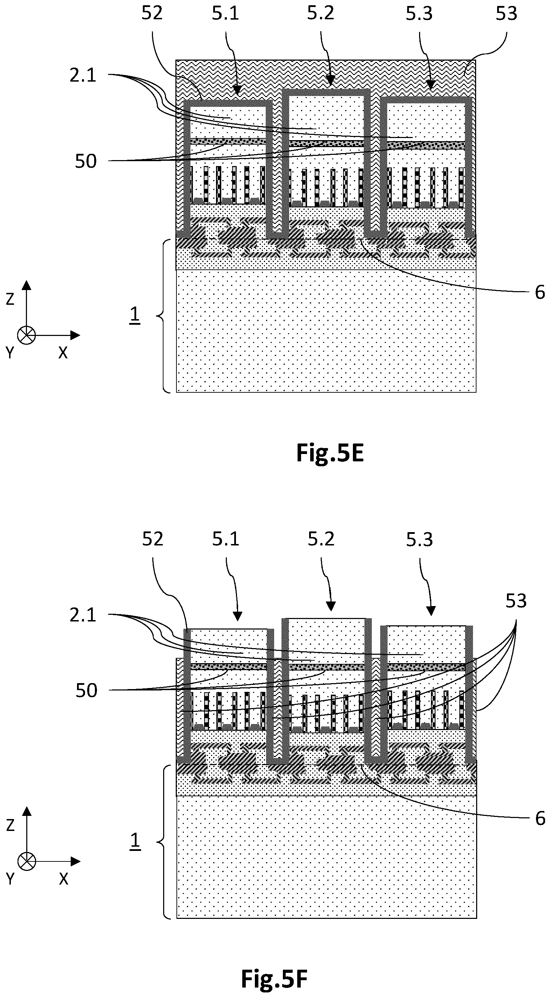

Dans une quatrième étape 64 dont le résultat est illustré par la **Figure 5E****,** on dépose tout d'abord une couche 53 de résine photosensible standard du marché (à tonalité positive ou négative), en vue de réaliser par photolithographie un masque utile pour découvrir les seules zones concernées par la gravure chimique à suivre, à savoir les surfaces supérieures du substrat arrière des puces individuelles rapportées 5.1, 5.2 et 5.3.

Cette résine (« *resist* » en anglais) est par exemple une résine relativement épaisse et visqueuse, pour avoir un bon pouvoir couvrant. En effet, il existe des creux et des bosses sur la surface à couvrir, en raison de la topologie de la surface de la microstructure, qui est empreinte de la TTV que l'on cherche à supprimer. L'épaisseur de la couche de résine 53 est par exemple de l'ordre de 25 µm. Elle peut être déposée par enduction centrifuge (« *spin coating* », en anglais), ou par tout autre procédé équivalent disponible.

Par exemple, la résine peut être la résine connue sous l'appellation commerciale AZ^{®} 3DT-102M-15^{™}, disponible auprès de la société MicroChemicals^{™}. Il s'agit d'une résine ayant un rapport d'aspect élevé. En variante, il peut aussi s'agir de la résine connue sous l'appellation commerciale PMER P-BZ4000^{™}, disponible auprès de la société TOK^{™}.

Dans une cinquième étape 65, dont le résultat est illustré par la **Figure 5F****,** on effectue une gravure sèche, donc fortement anisotrope, de la couche 53 de résine ainsi que du nitrure de la couche de protection 52 sous-jacente, au niveau du haut des puces rapportées 5.1, 5.2 et 5.3. Ceci permet de découvrir le silicium monocristallin 2.1 du substrat arrière 2.1 desdites puces, au niveau de la surface supérieure de la microstructure, sans abimer le reste de la microstructure. La gravure peut être une gravure au plasma (« *plasma etching* » en anglais), c'est-à-dire une gravure physique. Il peut aussi s'agir d'une gravure chimique sèche comme une gravure ionique réactive plus connue sous son acronyme anglophone, RIE (mis pour « *Reactive-lon Etching* », en anglais).

Du fait de leur anisotropie, ces gravures attaquent essentiellement le haut des puces 5.1, 5.2 et 5.3 et plus faiblement la zone inter-puces, mieux protégée par la couche de résine 53. Dit autrement, les zones en Nitrure de Silicium (SiN) entre les flancs verticaux de la couche de protection 52 sont protégées par la couche de résine 53. Cela permet de retirer le SiN de la couche de protection 52 uniquement sur la face arrière des puces 5.1, 5.2 et 5.3.

Dans une variante, la résine de la couche 53 et le "capping" en SiN de la couche de protection 52 peuvent aussi être enlevés, au niveau de la face arrière des puces 5.1, 5.2 et 5.3 seulement, par un polissage mécano-chimique (CMP). A la fin de cette étape de gravure sèche de la couche de nitrure 52, et comme représenté à la Figure 5F, le silicium 2.1 du substrat arrière des puces rapportées 5.1, 5.2 et 5.3 est découvert, en haut de la microstructure. Les portions verticales de la couche de protection 52 n'ont pas été affectées, ou alors très peu, par la gravure précitée, même si le masque de résine 53 a été endommagé dans ses parties supérieures, comme illustré symboliquement à la figure. En tout état de cause, le nitrure de la couche de protection 52 reste présent, et intègre, au fond des tranchées entre les puces individuelles rapportées 5.1, 5.2 et 5.3, à proximité de l'interface de collage 6, car il a été protégé à ces endroits par le masque formé par la couche de résine 53.

On appréciera que, après la gravure sélective ci-dessus, le nitrure de la couche de protection 52 peut être recouvert au niveau l'interface de collage 6 par des résidus de gravure et y est recouvert, au moins en partie, par ce qu'il reste du masque en résine 53 après la photolithographie et la gravure.

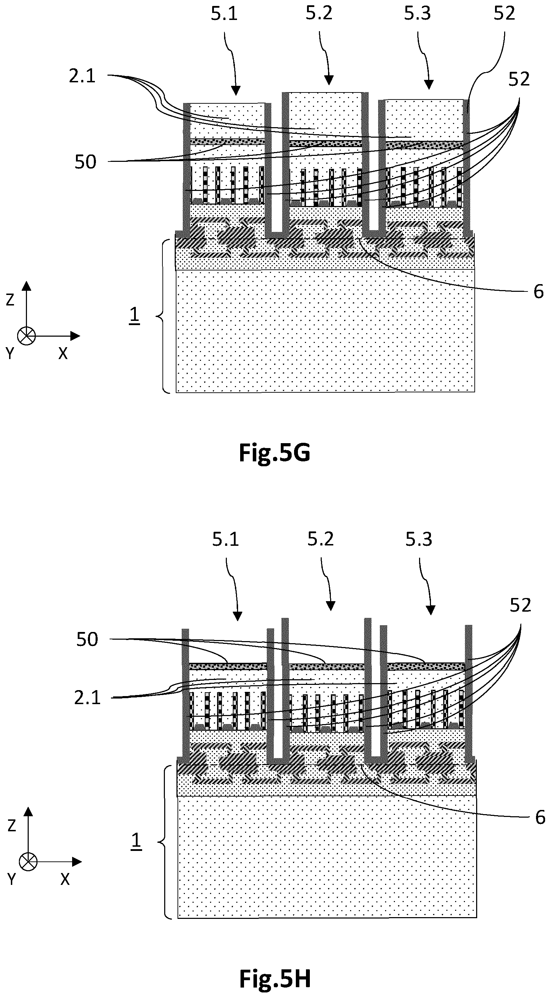

Il est donc nécessaire d'enlever les résidus du masque en résine 53 qui sont présents en fond de tranchées, *i.e.,* au fond des espaces en forme de tranchées qui existent entre les puces individuelles rapportées 5.1, 5.2 et 5.3. Ceci est l'objet d'une sixième étape 66 de la procédure, qui permet d'obtenir la microstructure conforme à la **Figure 5G**. Dans cette microstructure :
o- la face supérieure des puces individuelles rapportées 5.1, 5.2 et 5.3 expose le silicium du substrat arrière 2.1 desdites puces ; et,
o- les tranchées entre ces puces sont recouvertes et donc protégées par le nitrure de silicium de la couche de protection 52.

Pour ce faire, plusieurs procédés de retrait de la résine (« *stripping* », en anglais) peuvent être utilisés, notamment un retrait par un plasma et/ou un retrait par voie humide.

Dans des modes de réalisation, on peut enlever les portions résiduelles du masque en résine 53 par gravure humide, qui a l'avantage d'être isotrope. Ce type de gravure humide est purement chimique, le matériau correspondant à la résine étant modifié en surface par une solution d'attaque, puis cette partie est alors dissoute par un solvant. La répétition des étapes d'attaque chimique et de dissolution chimique alternées entraine la consommation progressive de la résine de photolithographie. La quantité de résine enlevée à chaque itération est pilotée par la durée de contact entre la résine et la solution d'attaque acide.

La résine peut être mise en contact avec la solution d'attaque soit par immersion de la plaque dans un bain de chimie, soit par dispense directe de la solution sur la plaque. Il peut s'agir de solutions alcalines aqueuses telles que le KOH ou le NaOH, par exemple à 2 % ou 3 %.

Le solvant peut être du NMP (1-méthyl-2-pyrrolidone), qui est adapté pour enlever les couches de résine photosensible en raison de sa très faible pression de vapeur. Ceci permet en effet de le chauffer à 80°C afin de pouvoir retirer des films de résine photosensible particulièrement réticulés. Un autre exemple de solvant adapté pour enlever les couches de résine photosensible est le DMSO (sulfoxyde de diméthyle) chauffé à 60-80°C. Ce solvant présente de bonnes performances en tant que décapant de résine photosensible.

Dans certains modes de réalisation, les deux procédés précités peuvent être combinés : un retrait par plasma (gravure sèche) permet alors de retirer la résine alors qu'un nettoyage humide effectué à la suite permet, le cas échéant, d'enlever les éventuels résidus restants.

Dans une variante de mise en oeuvre des étapes 64, 65 et 66 qui ont été décrites dans ce qui précède, on peut effectuer une gravure sèche anisotrope de la couche de protection 52 en Nitrure de Silicium (SiN) qui permet, par différence d'épaisseur de ladite couche 52 entre le haut des puces et la zone inter-puces, de retirer le SiN uniquement en haut des puces 5.1 ; 5.2 et 5.3, c'est-à-dire sur la face arrière desdites puces. Sur le diagramme d'étape de la Figure 6, cette variante est illustrée par une branche alternative aux blocs 64, 65 et 66, portant la référence 80. Avec cette variante, on passe directement de la structure représentée à la Figure 5D à celle représentée à la Figure 5G. Dit autrement, les états intermédiaires illustrés par la Figure 5E et la Figure 5F ne sont pas rencontrés dans le cadre de mises en oeuvre du procédé selon cette variante.

Dans une septième étape 67, on réalise une gravure chimique du substrat arrière des puces individuelles rapportées 5.1, 5.2 et 5.3, par exemple une gravure chimique humide. Cette gravure chimique a pour fonction, conformément à l'invention, de ramener le niveau du substrat arrière 2.1 de chacune desdites puces à la même hauteur sur le substrat poignée 1, comme montré à la **Figure 5H**. On rappelle en effet que, conformément aux modes de réalisation de l'invention, cette fonction d'aplanissement n'est pas recherchée par des processus de CMP comme le suggèrerait l'art antérieur, mais est dévolue à l'étape de gravure chimique 67 considérée ici. On parle donc ici d'une gravure de rectification en référence à la fonction de cette gravure. On appréciera que le recours à une étape de gravure chimique humide pour obtenir la rectification attendue est, en quelque sorte, contre nature dans la mesure où la personne de métier sait qu'une gravure chimique humide est fortement isotrope, et que sa mise en oeuvre est susceptible d'abimer des éléments au niveau des interfaces de collage 6 entre chacune des puces individuelles rapportées 5.1, 5.2 et 5.3, d'une part, et le dessus de la plaque poignée 1, d'autre part, comme des plots ou des pistes en cuivre qui ont été réalisés au niveau de cette interface. Comme on le reverra à nouveau plus loin, c'est le rôle de la couche de protection 52 que de protéger le fond des tranchées entre les puces individuelles rapportées 5.1, 5.2 et 5.3 lors de la mise en oeuvre de la gravure chimique humide qui réalise la rectification du substrat arrière 2.1 desdites puces.

La gravure de rectification 67 qui est mise en oeuvre est une gravure sélective par rapport à l'élément d'arrêt 50 compris dans le substrat arrière 2.1 de chacune des puces individuelles rapportées 5.1, 5.2 et 5.3. Par exemple, lorsque les éléments d'arrêt 50 sont des zones ayant un dopage de type P qui est différent du dopage de type P standard du substrat de silicium 2.1 des puces individuelles rapportées, les paramètres de la gravure de rectification sont tels que cette gravure est sélective audit dopage de type P différent des zones d'arrêt 50. Dit autrement, la gravure de rectification agit à l'encontre du substrat 2.1 normalement dopé mais n'a pas d'effet sur les zones de silicium 50 contenues dans ledit substrat et qui sont dopées différemment. Il s'ensuit que le substrat arrière 2.1 de chacune des puces individuelles rapportées 5.1, 5.2 et 5.3, qui est exposé à la gravure de rectification, est enlevé par le haut jusqu'à ce que le niveau des éléments d'arrêt 50 soit atteint. Comme le niveau (suivant la hauteur, *i.e*., suivant la direction verticale Z) des éléments d'arrêt 50 est, par conception, le même pour toutes les puces individuelles rapportées 5.1, 5.2 et 5.3, il s'ensuit que la hauteur desdites puces après l'arrêt de la gravure conditionné par la rencontre de ces éléments d'arrêt est égale pour toutes les puces. Dit autrement, l'épaisseur du substrat arrière 2.1 de chacune des puces rapportées 5.1, 5.2 et 5.3 est désormais uniforme sur toute sa surface, comme montré à la Figure 5H.

Dans des modes de réalisation, la gravure de rectification peut être une gravure chimique humide (« *chemical wet etching* » en anglais). Une telle gravure peut être réalisée à l'aide d'une solution acide. Pour un substrat en silicium, il peut s'agir par exemple d'une solution acide à base d'acide fluorhydrique (HF), ou d'acide nitrique (HNO3). Ces acides sont capables de réagir avec la couche de dioxyde de silicium qui se forme naturellement à la surface du silicium du substrat arrière 2.1 des puces individuelles rapportées 5.1, 5.2 et 5.3. Pour un substrat 2.1 en arséniure de gallium (AsGa), on préférerait une solution acide à base d'acide chlorhydrique (HCl) étant donné que l'ion chlorure réagit fortement avec le gallium. En variante ou en complément, on peut aussi utiliser une solution à base d'un acide plus faible, tel que l'acide citrique dilué à l'eau, par exemple à 50% de volume (C6H8O7 : H2O, 1 : 1), et/ou le peroxyde d'hydrogène (eau oxygénée - H2O2) dilué à l'eau (H2O).

Les effets, à l'encontre de l'intégrité de la structure microélectronique, du caractère fortement isotrope d'une telle gravure chimique humide sont prévenus grâce à la première couche de protection 51 complétée, le cas échéant (et comme représenté), par la seconde couche de protection 52, cette couche (ou ces couches) étant, dans l'exemple considéré ici, réalisée(s) en nitrure de silicium (SiN) ou dans un autre type de nitrure aux propriétés comparables. Le nitrure de silicium (par exemple Si₃N₄), en effet, n'est pas attaqué par une gravure humide du type précité.

Un avantage de la gravure humide par rapport à une gravure sèche (gravure physique, ou au plasma, ou encore par bombardement d'ions), est la possibilité de prévoir une sélectivité de la gravure. Conformément à l'invention, on exploite cette sélectivité pour définir des éléments d'arrêt de la gravure du substrat arrière des puces individuelles 5.1, 5.2 et 5.3 qui ont été rapportées sur le substrat poignée 1, pour obtenir l'uniformisation de la hauteur du substrat arrière desdites puces qui est recherchée.

En pratique, plusieurs mises en oeuvre d'une telle gravure sont envisageables, pour obtenir la sélectivité de la gravure chimique humide par rapport aux éléments d'arrêt 50.

Tout d'abord, et comme il a été exposé plus haut, le substrat arrière 2.1 des puces 5.1, 5.2 et 5.3 peut comporter des zones d'arrêt 50 ayant un dopage spécifique, formée avant la réalisation des puces à une profondeur déterminée dans le substrat arrière de la plaque (ou des plaques), dite(s) plaque(s) "produit", dans laquelle (ou dans lesquelles) les puces ont été réalisées. Une fois que les puces ont été individualisées par découpe depuis leur plaque produit, puis testées, et ensuite retournées et collées sur le substrat poignée1, les zones 50 respectives des puces individuelles rapportées se trouvent à une hauteur déterminée, et identique pour chacun de ces puces. Et ce d'autant plus si les puces ainsi rapportées proviennent du même substrat donneur, c'est-à-dire si elles ont été préalablement découpées d'une même et unique plaque produit. Cette zone de dopage 50 dans le substrat arrière des puces est une zone ayant un dopage qui diffère du dopage du silicium monocristallin du substrat 2.1, lequel peut par exemple être un dopage P standard. Le dopage des zones d'arrêt 50 peut être un dopage de type P également, mais avec une moindre concentration d'atomes accepteurs d'électrons. La détection des zones 50 peut alors conditionner l'arrêt de la gravure chimique humide, et ce à un niveau (*i.e*., à une hauteur) qui est identique pour toutes les puces. On obtient ainsi l'effet de sélectivité de la gravure qui procure la rectification recherchée de la hauteur du substrat arrière des puces rapportées respectives.

En variante, on peut prévoir un arrêt par détection d'un matériau différent dans le substrat, par exemple de l'arséniure de gallium (GaAs) ou de l'aluminium (Al), si le substrat arrière 2.1 des puces individuelles rapportées 5.1, 5.2 et 5.3 est un substrat composite. Dit autrement, les éléments d'arrêt 50 peuvent être des éléments en un matériau spécifique qui ont été réalisés dans le substrat arrière 2.1 des puces individuelles rapportées 5.1, 5.2 et 5.3 préalablement à la formation des dispositifs formant lesdites puces, et notamment des dispositifs photosensibles en technologie CMOS réalisés sur ce substrat 2.1.

En variante encore, et notamment mais pas uniquement dans le cas où le substrat arrière 2.1 des puces individuelles rapportées 5.1, 5.2 et 5.3 est un substrat de silicium épitaxié de quelques micromètres (µm) d'épaisseur, on peut prévoir comme élément d'arrêt de la gravure de rectification une fine couche dédiée. Il peut s'agir d'une couche réalisée dans le substrat 2.1 en un matériau spécifique, telle qu'une fine couche d'oxyde de silicium (SiO2) ou une fine couche de nitrure de silicium (par exemple du Si₃N₄). Comme la personne du métier le sait bien, dans le contexte des substrats épitaxiés on entend par "fine couche" une couche dont l'épaisseur peut être comprise entre quelques nanomètres et quelques dizaines de nanomètres, par exemple entre 5 à 8 nm pour la limite basse, et 50 à 80 nm pour la limite haute.

Enfin, l'élément 50 d'arrêt de la gravure de rectification peut aussi être une couche d'arrêt enterrée, comme la couche d'oxyde enterrée ou BOX (de l'anglais « *Burried Oxyde* ») dans où le cas où le substrat arrière 2.1 des puces individuelles rapportées 5.1, 5.2 et 5.3 est un substrat de silicium sur isolant ou SOI (de l'anglais « *Silicon-on-Insulator* »).

Quel que soit le mode de réalisation des éléments 50 prévus pour l'arrêt de la gravure de rectification, la gravure par voie chimique qui est réalisée est sélective par rapport à ces éléments d'arrêt 50, et permet une rectification satisfaisante de la surface du substrat arrière des puces individuelles rapportées 5.1, 5.2 et 5.3.

La gravure de rectification de cette étape 67 permet, en complément de l'étape 62 de meulage de pré-amincissement par CMP, non seulement d'achever l'amincissement afin de descendre le niveau du substrat arrière de chacune des puces de la microstructure à la hauteur déterminée par le niveau des éléments d'arrêt 50, mais également et surtout d'obtenir une bonne uniformité desdits niveaux, par exemple avec une TTV réduite à une valeur de l'ordre de ± 5 nm. La principale fonction de l'étape de gravure de rectification est ainsi de gommer la TTV qui a été introduite du fait de l'étape de meulage de pré-amincissement par CMP, et qui était au minimum de 2,5 µm environ.

La personne de métier appréciera que, durant la mise en oeuvre de l'étape de gravure chimique humide 67 lors de l'étape de rectification ci-dessus, et nonobstant le caractère fortement isotrope d'une telle gravure, la seconde couche de protection 52 en nitrure de silicium (SiN) résiste. Elle assure ainsi son rôle consistant à protéger le fond des tranchées entre les puces individuelles rapportées 5.1, 5.2 et 5.3. C'est là en effet qu'il existe des éléments à protéger car leur intégrité doit être préservée, comme les métallisations réalisées à l'interfaces de collage 6 entre chacune des puces individuelles rapportées 5.1, 5.2 et 5.3, d'une part, et le dessus de la plaque poignée 1, d'autre part. En particulier, il existe au niveau de cette interface 6 des plots ou des pistes en cuivre, qui ne doivent pas être attaquées.

La personne du métier appréciera que, dans des variantes, d'autres techniques d'amincissement sélectives peuvent être mise en oeuvre, à la place de la gravure chimique humide. Par exemple, on peut effectuer un amincissement par polissage mécano-chimique (CMP) après le meulage de pré-amincissement, avec arrêt dans une couche dopée ou implantée formant un élément d'arrêt 50 pour la CMP.

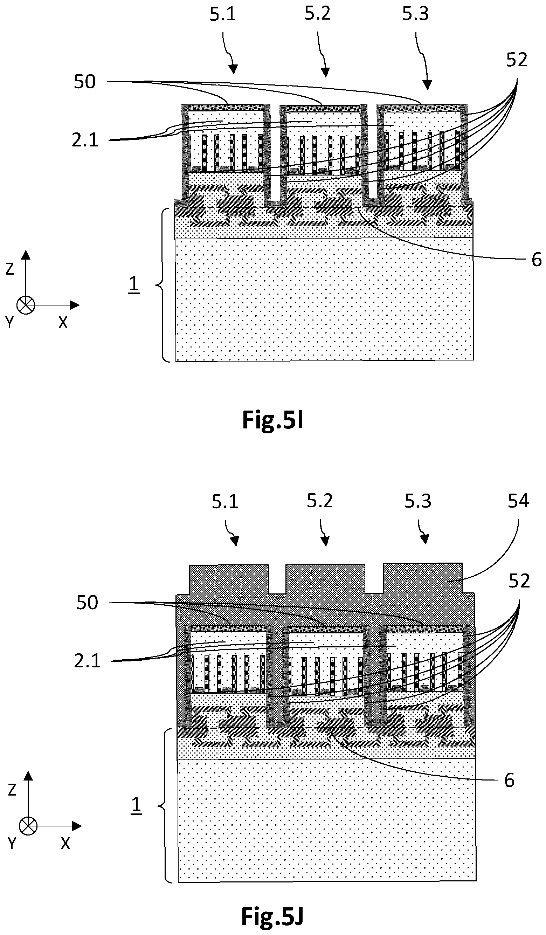

Dans une huitième étape 68, on rogne les portions en nitrure de silicium correspondant aux flancs verticaux de la couche de protection 52, qui font saillie vers le haut à partir du silicium des éléments d'arrêt 50. Ces portions ont été laissées intactes par les attaques chimiques appliquées à la microstructure lors de l'étape 67 de gravure chimique humide exposée ci-dessus. Elles forment des sortes d'épines pointant vers le haut à partir du niveau des éléments d'arrêt 50, comme il est visible à la Figure 5H. Une fois que ces épines ont été rognées par la mise en oeuvre de cette huitième étape 68, on obtient la structure telle qu'elle est montrée à la **Figure 5I****.**

Cette étape 68 peut être réalisée par polissage de type CMP. En pratique, les temps de polissage sont très courts, et leur détermination résulte de la seule expérimentation. En effet, le nitrure de silicium s'entame très vite sous l'effet du CMP. Et, par ailleurs, il n'existe pas de moyen de détecter automatiquement qu'on a atteint le niveau du silicium du substrat arrière des puces individuelles rapportées 5.1, 5.2 et 5.3.

A l'issue de cette étape 68, et comme montré à la Figure 5I, le niveau supérieur des puces individuelles rapportées 5.1, 5.2 et 5.3 est rectifié, c'est-à-dire que le niveau du substrat arrière des puces individuelles rapportées 5.1, 5.2 et 5.3 a été uniformisé, à quelques nanomètres près, par exemple à ±5 nm près. La surface supérieure de la microstructure n'est toutefois pas encore exactement plane, étant donné qu'il demeure les tranchées entre lesdites puces.

Les étapes sui suivent visent à combler ces tranchées (étape 69) et ensuite à polir (étape 70) le dessus de la microstructure, afin d'obtenir une surface supérieure de la microstructure qui soit bien plane.

Dans une neuvième étape 69, on forme une couche 54 de matériau diélectrique pour réaliser un comblement (« *interfill* ») des espaces entre les puces individuelles rapportées 5.1, 5.2 et 5.3. L'épaisseur de la couche de comblement 54 est comprise, par exemple, entre environ 20 µm et environ 25 µm. Le matériau de comblement est par exemple un oxyde épais. Cette étape 69 permet de combler les espaces libres entre lesdites puces, jusqu'au fond des tranchées qui séparent ces puces, ainsi qu'il est montré à la **Figure 5J** qui illustre la microstructure après la réalisation de la couche d'oxyde de comblement 54. Dit autrement, la couche d'oxyde 54 permet de combler les irrégularités et les aspérités présentes sur la surface supérieure de la microstructure.

La personne de métier appréciera que, selon l'invention, le comblement des tranchées entre les puces individuelles rapportées 5.1, 5.2 et 5.3 n'est avantageusement réalisé qu'en fin de protocole seulement, c'est-à-dire une fois que le substrat arrière desdites puces a été aminci et que la surface supérieure de la microstructure a ensuite été aplanie. De la sorte, l'oxyde de comblement n'est pas affecté par les opérations d'amincissement par CMP (étape 62) et de rectification par gravure chimique humide (étape 67) du substrat arrière, qui ont précédé sa réalisation. L'oxyde de comblement n'a donc pas besoin d'être réparé ni complété du fait de l'amincissement et de la rectification exécutés.

Pour réaliser la couche d'oxyde de comblement 54, on peut par exemple réaliser une couche d'oxyde "pleine plaque", par exemple de dioxyde de silicium (SiO2) qui est le matériau diélectrique le plus couramment utilisé dans le traitement des dispositifs semi-conducteurs.

Le dépôt peut être un dépôt effectué par voie chimique, comme par exemple un dépôt chimique en phase vapeur assisté pas plasma (PECVD, mis pour « *Plasma Enhanced Chemical Vapor Déposition* » en anglais), d'orthosilicate de tétraéthyle (ou TEOS mis pour "tetraethylorthosilicate") comme précurseur du dioxyde de silicium (SiO2), suivi d'une simple hydrolyse qui permet de former du SiO2 en libérant de l'éthanol (CH3CH2OH). Un tel dépôt est un procédé de dépôt conforme, c'est-à-dire que la couche d'oxyde de comblement 54 qui est déposée épouse parfaitement le relief de la microstructure qui en est recouverte. Avantageusement, la température relativement moyenne à laquelle s'effectue un dépôt par PECVD est compatible avec le respect des matériaux des composants du dispositif. En effet, la réaction chimique de décomposition des gaz précurseurs qui est à l'origine du dépôt, est assistée par une décharge électrique radiofréquence (à 13,56 MHz) qui ionise les gaz et forme un plasma (à savoir un mélange globalement neutre constitué d'ions et d'électrons). Cela permet de réaliser le dépôt en maintenant le dispositif à une température inférieure à 500°C environ, alors qu'avec une méthode de CVD classique à basse pression, la décomposition des gaz précurseurs est obtenue en appliquant des températures relativement plus élevées (typiquement de l'ordre de 1000°C environ). En variante, le dépôt peut aussi être réalisé par un procédé physique, comme la pulvérisation cathodique, ou des méthodes de dépôt par centrifugation (« *spin-of* », en anglais).

Comme il est apparent à la Figure 5J, ce dépôt crée une topographie à la surface supérieure du dispositif, qui suit le relief correspondant aux extrémités supérieures des puces individuelles rapportées 5.1, 5.2 et 5.3 sur la plaque poignée 1.

Dans une dixième étape 70, on procède au polissage mécano-chimique (CMP) de la couche d'oxyde, qui assure l'aplanissement (c'est-à-dire le nivellement) de la surface par l'action combinée de forces mécaniques et chimiques. Cette étape 70 permet de rattraper la topographie provoquée par le dépôt de la couche d'oxyde 54 effectué à l'étape 69 précédente, afin d'établir la planéité de la surface supérieure de la microstructure. Le polissage peut être arrêté de deux manières différentes, dont les deux modes de mise en oeuvre décrits ci-dessous.

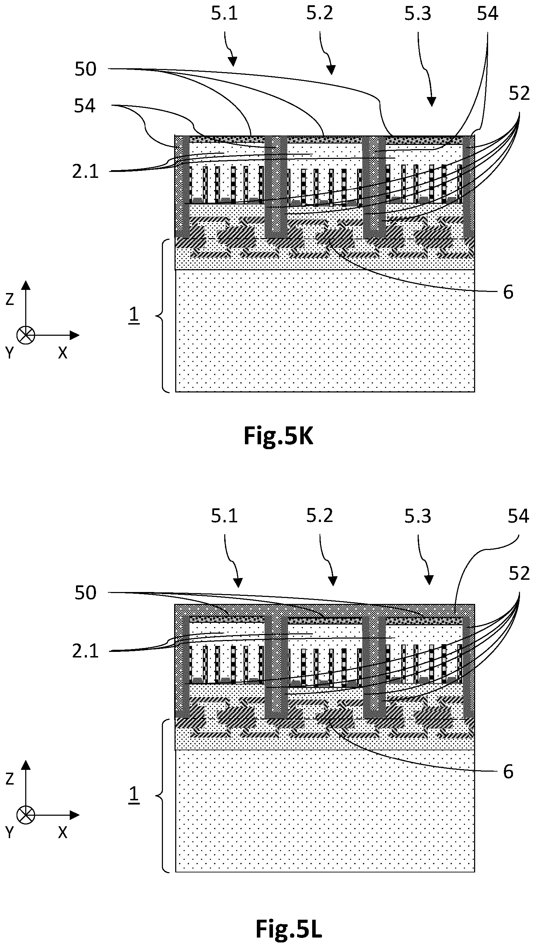

Dans un premier mode de mise en oeuvre, dont le résultat est illustré par la **Figure 5K****,** le retrait par CMP de l'oxyde de la couche 54 peut être arrêté sur détection des éléments d'arrêt 50 en silicium ou en oxyde, qui ont déjà été utilisés comme éléments d'arrêt lors de la gravure de rectification par voie chimique effectuée à la septième étape 67 qui a été explicitée dans ce qui précède. Plus particulièrement, le polissage mécanochimique peut être arrêté sur détection d'une élévation du couple de la machine de polissage qui résulte du changement de la friction au contact des éléments d'arrêt. Ce mode de mise en oeuvre est plus adapté à la réalisation de la onzième et dernière étape en vue de la réalisation d'un imageur (voir plus bas).

Dans un autre mode de mise en oeuvre, alternatif, le polissage peut être arrêté après un temps déterminé, et/ou sur commande par des capteurs de fin de course (« *endpoints* », en anglais) prévus dans la machine de polissage. Ce mode de mise en oeuvre permet d'arrêter le polissage à un niveau situé dans la couche d'oxyde 54, comme montré à la **Figure 5L****.** Cette mise en oeuvre donne la possibilité de refaire du collage de type D2W ou de type W2W par-dessus la microstructure, afin d'empiler de nouvelles puces toujours sur le même substrat poignée 1. En effet, de nouvelles pistes métalliques et/ou de nouveaux plots métallique de collage, comme les pistes 1.3.1 et les plots 1.3.2 du substrat poignée 1 de de la Figure 1A peuvent être formés, par un procédé de type Damascène ou Dual-Damascène, dans la couche d'oxyde 54 elle-même.

La personne du métier appréciera que, quelle que soit la mise en oeuvre choisie pour l'étape 70, le polissage de la couche d'oxyde 54 donne un bon résultat, i.e. une planéité satisfaisante de la surface de la microstructure après polissage, car le substrat arrière des puces individuelles rapportées 5.1, 5.2 et 5.3 ont été ramenées à la même hauteur grâce aux étapes antérieures du procédé. En effet, le polissage par CMP réalisé à cette dixième étape crée peu de marches au droit des tranchées séparant lesdites puces 5.1, 5.2 et 5.3, contrairement à des étapes de polissage qui seraient directement et uniquement réalisées pour amincir et uniformiser l'épaisseur du substrat arrière de ces puces rapportées. Il n'y a donc pas besoin de reformer du nitrure de silicium de la couche 52, ni de l'oxyde de silicium de la couche 54.

Dit autrement, on obtient une microstructure qui se présente comme un ensemble monolithique à surface supérieure est bien plane, avec une TTV ramenée à ±5 nm seulement.

Lorsque les puces sont, comme dans l'exemple non limitatif considéré dans la présente description, des photodiodes à grille de transfert verticale (VTG) et à isolation capacitive en tranchée profonde (CDTI) pour la réalisation d'un imageur de type BSI-CMOS, le procédé peut comprendre une onzième et dernière étape 71, qui est une étape de polissage dont le résultat est montré à la **Figure 5M**. Ce polissage peut être mis en oeuvre par voie mécanochimique (CMP).

Il n'est pas sélectif au matériau des éléments d'arrêt 50 (*i.e*., pas sélectif au silicium dopé P dans l'exemple où ces éléments sont des zones du substrat arrière 2.1 des puces 5.1, 5.2 et 5.3 réalisées avec un tel dopage), et il n'est pas non plus sélectif au matériau de la couche de protection 52 (*i.e.,* pas sélectif au nitrure de silicium dans l'exemple de réalisation des étapes 61 et 63 donné ici). Il permet ainsi de découvrir, en une seule étape, les extrémités arrière des tranchées profondes 2.5 d'isolation capacitive des puces individuelles rapportées 5.1, 5.2 et 5.3, c'est-à-dire de les exposer du côté de la face supérieure de la microstructure. On notera que la microstructure obtenue correspond à une microstructure identique, en termes de traitements effectués, à celle représentée en bas à droite de la Figure 4, laquelle correspond au dispositif photosensible d'un unique pixel seulement alors que la Figure 5M montre trois tels dispositifs, convenant pour la réalisation d'un pixel en trichromatie RGB.

Comme l'homme du métier l'aura compris, cette étape 71 est spécifique de la réalisation d'un imageur. L'ouverture de l'oxyde isolant jusqu'à découvrir les extrémités supérieures des tranchées profondes d'isolation capacitive des photodiodes permet en effet (par l'intermédiaire d'une (ou plusieurs) couche(s) de métallisation appropriée(s) à réaliser à cet effet), de polariser les tranchées capacitives 2.5 afin de rendre les dispositifs photosensibles opérationnels. A défaut, l'imageur concerné par l'exemple d'application du procédé qui a été considéré dans la présente description, ne fonctionnerait pas. On rappelle toutefois que l'invention ne se limite pas à cet exemple, mais s'applique à la phase d'amincissement de tout type de puces individuelles retournées et rapportées par collage sur un substrat poignée.

De manière plus générale, l'invention n'est pas limitée aux modes de réalisation particuliers précédemment décrits. Différentes variantes et modifications apparaîtront à la personne de métier. L'invention s'étend à tous les modes de réalisation couverts par les revendications.

Il est ainsi précisé que dans le cadre de la présente invention, le terme « puce » s'entend de tout élément microélectronique destiné à être transféré sur un dispositif, en particulier sur un support de plus grande dimension que la puce. Ces puces peuvent être traitées ou non, ou encore réalisées à base de silicium ou à base d'autres matériaux comme l'InP, par exemple, ou encore aussi être en AsGa, en carbure de silicium (SiC), en Silice, en Germanium (Ge) ou en Saphir et avoir en surface des couches de matériaux comme la silice, du nitrure de silicium (SiN), des métaux comme le cuivre (Cu) ou le titane (Ti), et toutes autres couches de matériaux connus dans le domaine de la microélectronique (HfO2, SiOC, AlN, Al2O3, GaN, ...).

Typiquement, les puces peuvent contenir des circuits intégrés, qui peuvent être connectés à l'extérieur au moyen de parties d'interconnexion électrique. Ces interconnexions peuvent être réalisées directement à l'interface de collage. Ces parties de raccordement électrique peuvent avoir des dimensions inférieures à 5 µm, ce qui implique une précision de placement des puces très élevée, de l'ordre d'un micromètre par exemple.

Les puces peuvent faire l'objet d'un traitement préalable à la mise en oeuvre du transfert ici proposé, mais aussi d'un traitement ultérieur. De tels traitements peuvent comprendre, de façon non exhaustive, l'intégration de circuits, la réalisation de vias, et/ou la réalisation de tout composant(s) supplémentaire(s) actif(s) ou passif(s). Par exemple, le transfert de puces peut être réalisé sur la base de puces non encore totalement formées, éventuellement encore simplement constituées d'un simple bloc de matière homogène destiné à être transformé ultérieurement.

De préférence, toutefois, les puces à transférer sont des dispositifs fonctionnels qui ont avantageusement été préalablement triées en étant soumis à un test électrique, de sorte que d'éventuelles puces non-fonctionnelles ont été éliminées, le cas échéant. On n'a donc transféré sur le substrat de destination (substrat "poignée") que des puces dont l'état fonctionnel a été vérifié. Ceci réduit, voire élimine le risque que l'ensemble du dispositif en cours de fabrication, à savoir l'imageur dans l'exemple, soit rendu non-fonctionnel du fait de la non-fonctionnalité d'une puce individuelle quelconque, à savoir l'une quelconque des photodiodes 41, 42 et 43 dans l'exemple.

La personne de métier appréciera, en outre, que la mise en oeuvre du procédé peut être opérée de manière simultanée pour une pluralité de puces individuelles qui ont été transférées sur la plaque poignée 1.

Il va sans dire également que, bien qu'étant individualisées, des puces peuvent être rapportées en lot sur la plaque poignée 1, et non une-à-une séparément par un outil de collecte et de placement, afin de gagner du temps.

## Revendications

1. Procédé de réalisation d'un dispositif microélectronique comprenant le collage hybride d'une pluralité de puces individuelles (5.1,5.2,5.3) qui sont retournées verticalement puis rapportées par collage sur une plaque de matériau semiconducteur, ou plaque poignée (1), le procédé comprenant, après le collage des puces individuelles rapportées sur la plaque poignée, un protocole d'amincissement du substrat arrière des puces individuelles (5.1,5.2,5.3) rapportées sur la plaque poignée qui comprend :
- un meulage de pré-amincissement (62) du substrat arrière des puces individuelles (5.1,5.2,5.3) rapportées sur la plaque poignée, précédé de la formation (61) d'une première couche de protection (51) de tranchées formées par des espaces entre les puces individuelles rapportées sur la plaque poignée, qui sont non-concernées par ledit meulage de pré-amincissement (62) ;
- suivi d'une gravure de rectification (67) de la hauteur du substrat arrière de chacune des puces individuelles (5.1,5.2,5.3) rapportées sur la plaque poignée, exécutée par voie chimique humide desdits substrats, ladite gravure chimique humide étant sélective à l'égard d'un élément d'arrêt (50) contenu dans les substrats et qui est utilisé pour arrêter la gravure à un niveau sensiblement uniforme pour chacune desdites puces.

2. Procédé selon la revendication 1, comprenant en outre, entre le meulage de pré-amincissement (62) et la gravure de rectification (67), la formation (63) d'une seconde couche (52) de protection des tranchées formées par les espaces entre les puces individuelles rapportées sur la plaque poignée, qui sont non-concernées par ladite gravure de rectification (67).

3. Procédé selon la revendication 2, comprenant en outre le retrait de la seconde couche (52) de protection au niveau uniquement des portions planes du substrat arrière (2.1) des puces individuelles rapportées (5.1,5.2,5.3), par gravure à travers un masque préalablement obtenu par photolithographie d'une couche de résine photosensible (53), pour découvrir sélectivement le substrat arrière (2.1) desdites puces en vue de la gravure de rectification (67) par voie chimique humide.

4. Procédé selon l'une quelconques des revendications 1 à 3, dans lequel le matériau de la première couche de protection (51) et/ou le matériau de la seconde couche de protection (52) sont des matériaux à base nitrure, notamment à base de nitrure de silicium.

5. Procédé selon l'une quelconques des revendications 1 à 4, dans lequel la gravure de rectification (67) par voie chimique humide est exécutée en utilisant, comme éléments (50) d'arrêt de ladite gravure, une zone ayant un dopage particulier dans le substrat arrière (2.1) de chacune des puces individuelles rapportées (5.1,5.2,5.3), qui est réalisée dans lesdits substrats (2.1) à une profondeur déterminée, laquelle profondeur est sensiblement identique pour chacune desdites puces (5.1,5.2,5.3).

6. Procédé selon la revendication 5, dans lequel le dopage particulier de la zone du substrat arrière de chacune des puces individuelles rapportées (5.1,5.2,5.3) qui est utilisée comme élément d'arrêt de la gravure chimique humide, est un dopage de type P différent du dopage de type P standard dudit substrat arrière.

7. Procédé selon l'une quelconques des revendications 1 à 4 dans lequel, le substrat arrière (2.1) de chacune des puces individuelles rapportées (5.1,5.2,5.3) étant un substrat composite, la gravure de rectification (67) par voie chimique humide est exécutée en utilisant, comme éléments (50) d'arrêt de ladite gravure, une couche du substrat composite (2.1) de chacune des puces individuelles rapportées (5.1,5.2,5.3), qui est réalisée en un matériau spécifique à une profondeur déterminée dans lesdits substrats composites (2.1), laquelle profondeur est sensiblement identique pour chacune desdites puces (5.1,5.2,5.3).

8. Procédé selon la revendication 7, dans lequel le matériau spécifique dans lequel sont réalisés les éléments (50) d'arrêt de la gravure de rectification (67) par voie chimique humide est un matériau à base d'arséniure de gallium (GaAs), ou à base d'aluminium (Al).

9. Procédé selon l'une quelconques des revendications 1 à 4 dans lequel, le substrat arrière (2.1) de chacune des puces individuelles rapportées (5.1,5.2,5.3) étant un substrat de silicium épitaxié de quelques micromètres d'épaisseur, la gravure de rectification (67) par voie chimique humide est exécutée en utilisant, comme éléments d'arrêt (50) de ladite gravure, une fine couche du substrat de silicium épitaxié (2.1) de chacune des puces individuelles rapportées (5.1,5.2,5.3), qui est réalisée en un matériau spécifique à une profondeur déterminée dans lesdits substrats (2.1), laquelle profondeur est sensiblement identique pour chacune desdites puces (5.1,5.2,5.3).

10. Procédé selon la revendication 9, dans lequel la fine couche utilisée comme élément (50) d'arrêt de la gravure de rectification (67) par voie chimique humide est une fine couche d'oxyde de silicium (SiO2), ou une fine couche de nitrure de silicium (Si3N4).

11. Procédé selon l'une quelconques des revendications 1 à 4 dans lequel, le substrat arrière (2.1) de chacune des puces individuelles rapportées (5.1,5.2,5.3) étant un substrat de silicium-sur-isolant, ou SOI (de l'anglais « *Silicon-on-Insulator* »), la gravure de rectification (67) par voie chimique humide est exécutée en utilisant, comme éléments d'arrêt (50) de ladite gravure, une couche enterrée dans le substrat SOI de chacune des puces individuelles rapportées (5.1,5.2,5.3), qui est réalisée à une profondeur déterminée dans lesdits substrats SOI, laquelle profondeur est identique pour chacune desdites puces (5.1,5.2,5.3).

12. Procédé selon la revendication 11, dans lequel la couche enterrée du substrat SOI de chacune des puces individuelles rapportées qui est utilisée comme élément d'arrêt de la gravure de rectification (67) par voie chimique humide, est une couche d'oxyde enterrée, ou BOX (de l'anglais « *Burried Oxyde* ») dudit substrat.

13. Procédé selon l'une quelconques des revendications 1 à 12, dans lequel les puces individuelles rapportées sont des puces préalablement découpées d'une même et unique plaque de matériau semiconducteur donneuse (2).

14. Procédé selon l'une quelconques des revendications 1 à 13, dans lequel la plaque poignée est une plaque réalisée en technologie CMOS traditionnelle.

15. Procédé selon l'une quelconques des revendications 1 à 14, dans lequel le pré- amincissement (62) du substrat arrière des puces individuelles (5.1,5.2,5.3) rapportées sur la plaque poignée est exécuté par meulage.

16. Procédé selon l'une quelconques des revendications 1 à 14, dans lequel le pré-amincissement (62) du substrat arrière des puces individuelles (5.1,5.2,5.3) rapportées sur la plaque poignée est exécuté par un procédé connu sous le nom SmartCut^{™} comprenant une implantation ionique et un recuit de fractionnement.

17. Procédé selon l'une quelconques des revendications 1 à 16, dans lequel les puces individuelles (5.1,5.2,5.3) sont triées, préalablement à leur report sur la plaque poignée (1), sur la base des résultats d'un test, de manière à écarter d'éventuelles puces non-fonctionnelles et ne reporter par collage sur la plaque poignée que des puces fonctionnelles uniquement.

18. Procédé selon la revendication 17, dans lequel le test est un test de bon fonctionnement électrique des puces.

19. Imageur couleurs (20) de type BSI (de l'anglais « *BackSide Illumination* ») comprenant un dispositif microélectronique (1,2) avec une matrice d'éléments photosensibles (2), dans lequel :
- les éléments photosensibles sont des puces individuelles (2) rapportées sur une plaque de matériau semiconducteur, ou plaque poignée (1); et,
- le substrat arrière des puces individuelles (2) rapportées sur le substrat poignée (1) a été traité par la mise en oeuvre du procédé selon l'une quelconque des revendications 1 à 18,
l'imageur comprenant en outre une matrice de filtres colorés (3) et une matrice de microlentilles (4) réalisées par-dessus le dispositif microélectronique (1,2).
